# EUROPEAN PATENT APPLICATION

(11) **EP 2 858 133 A1**
(43) Date of publication of application: **08.04.2015**
(21) Application number: 13800723.2
(22) Date of filing: 26.04.2013
(51) Int. Cl.: H01L 33/60, C08F 283/01, C08F 290/00

(54) **CRYSTALLINE UNSATURATED POLYESTER RESIN COMPOSITION FOR LED REFLECTOR, GRANULAR MATERIAL COMPRISING SAID COMPOSITION, LED REFLECTOR PRODUCED BY MOLDING SAID GRANULAR MATERIAL, SURFACE-MOUNT-TYPE LIGHT-EMITTING DEVICE, AND LIGHTING DEVICE AND IMAGE DISPLAY DEVICE EACH EQUIPPED WITH SAID LIGHT-EMITTING DEVICE**

(30) Priority: 04.06.2012 JP 2012127464; 13.07.2012 JP 2012157440; 11.10.2012 JP 2012225712; 21.12.2012 JP 2012279897
(71) Applicant: Japan U-PICA Company, Ltd, Chiyoda-ku Tokyo 102-0094 (JP)
(72) Inventor: OYAMA, Tomohito, Hiratsuka-city, Kanagawa 254-0016 (JP)
(74) Representative: Fiussello, Francesco
(86) International application number: PCT/JP2013/002857
(87) International publication number: WO 2013/183219

(57) **Abstract**

The purpose of the present invention is to provide a crystalline unsaturated polyester resin composition which has improved fluidability upon being mixed with an inorganic filler, a white pigment or the like.

A crystalline unsaturated polyester resin composition for an LED reflector according to the present invention is a crystalline unsaturated polyester resin composition comprising at least a crystalline unsaturated polyester resin and an inorganic filler, and is characterized in that the crystalline unsaturated polyester resin comprises a crystalline unsaturated polyester and a copolymerizable monomer and/or a copolymerizable prepolymer and the crystalline unsaturated polyester resin composition contains a white pigment. A preferred embodiment of the crystalline unsaturated polyester resin composition for an LED reflector according to the present invention is characterized in that the crystalline unsaturated polyester resin has a solid state in a temperature range that does not exceed 50°C.

## Description

### Technical Field

The present invention relates to an unsaturated polyester resin composition for LED reflector, a granular material comprising said composition, LED reflector produced by molding said granular material, and particularly relates to a crystalline unsaturated polyester resin composition, a granular material comprising said composition, LED reflector produced by molding said granular material.

Further, in particular, the present invention relates to an unsaturated polyester resin composition containing a thermoplastic resin for LED reflector, a granular material comprising said composition, LED reflector produced by molding said granular material.

Further, the present invention relates to a radical polymerizable resin composition for LED reflector, a granular material comprising said composition, a molding method using the granular material, and LED reflector.

Further, the present invention relates to a surface-mount-type light-emitting device with the LED reflector produced by molding an unsaturated polyester resin composition, and a lighting device and image display device each equipped with said light-emitting device.

### Background Art

LED is used for a lot of applications taking advantage of merits such as low power consumption, longer operating life, miniaturization, weight saving, and fast response, in recent day, becoming widely used as energy-saving products and as a light source for general consumer. Under this circumstance, amount of light and current of LED substituted from an existing light source also becomes large, and thereby increasing emitted light and injected current density to increase heat release value. Therefore, since degradation of the peripheral material used for LED occurs, a high performance and a high credibility material is desired.

A reflector can reflect a light of LED to the front to improve a brightness. It is required that in an material of the reflector, initial brightness is superior, and a reflectance is high, even if it is used for long time, there is little discoloration by heat and light.

In tandem with the penetration of LED, further a high-powered LED is under review. There are some problems that according to high power the thermoplastic resin used as a material for a reflector is easily to discolor by strong light of high brightness LED or a high temperature of the surface of a chip to reduce a reflecting efficiency of light, and to reduce a brightness of LED.

A surface-mount-type light-emitting device, such as LED mainly comprises a semiconductor element, a lead frame, a light reflector, sealant.

Recently, in addition to a superior heat discoloration resistance capable of maintaining a high reflectance over long periods of time, as well as a smoothing feature of the surface of the LED light reflector has been required which is revaluated with shrinkage or image clarity.

In the past, an LED reflector with a superior performance of heat discoloration-resistance made by ceramics is known (for example, patent literature 1). Moreover, a general LED light reflector comprising a liquid crystalline polyester resin wherein an injection molding can be carried out and productivity is superior (for example, patent literature 2). Further, an LED light reflector made by epoxide resin with a superior initial reflectance is known (for example, patent literature 3). Moreover, a general LED light reflector made by semiaromatic polyamide resin is known (for example, patent literature 4). These semiaromatic polyamide resin has a high initial reflectance and is low cost.

Furthermore, in order to solve the problems of the above LED light reflector made by semiaromatic polyamide resin, a resin composition for an LED light reflector comprising an unsaturated polyester resin with heat discoloration resistance wherein an injection molding can be carried out, and an LED light reflector comprising the resin composition is known (for example, patent literature 5). A resin composition comprising an unsaturated polyester resin in patent literature 5 is an amorphous unsaturated polyester resin composition, it is possible to solve the problems in the case that it comprises semiaromatic polyamide resin.

In the past, as a light-emitting device, a surface-mount-type light-emitting device with a reflector wherein ceramic having a superior heat-discoloration resistance is molded (for example, patent literature 6). Further, a surface-mount-type light-emitting device with a reflector wherein epoxy resin composition having a high initial reflectance is molded (for example, patent literature 7). Moreover, a surface-mount-type light-emitting device with a reflector wherein semiaromatic polyamide resin is molded (for example, patent literature 8). These semiaromatic polyamide resin composition has a high initial reflectance and is low cost.

Furthermore, in order to solve problems of a surface-mount-type light-emitting device with a reflector wherein semiaromatic polyamide resin is molded, a surface-mount-type light-emitting device with a reflector wherein an unsaturated polyester resin with heat discoloration resistance and an injection molding can be carried out is molded, is known (for example, patent literature 9). The surface-mount-type light-emitting device with a reflector wherein an unsaturated polyester resin is molded in the patent literature 9 makes it possible to solve problems of a surface-mount-type light-emitting device with a reflector wherein semiaromatic polyamide resin is molded.

### Prior art literature

### Patent literature

Patent literature 1 : WO2006/013899
Patent literature 2 : JP-A1-2010-235810
Patent literature 3 : JP-A1-2006-140207
Patent literature 4 : JP-A1-2008-182172
Patent literature 5 : JP-A2-4844699
Patent literature 6 : JP-A2-4674487
Patent literature 7 : JP-A1-2009-272616
Patent literature 8 : JP-A1-2012-167285
Patent literature 9 : JP-A2-4893874

### Disclosure of the Invention

### Problems to be resolved by the invention

However, in the above patent literatures 1 and 6, although ceramics has extremely superior heat resistance, since productivity thereof is low and cost is high, it is not practically used as a general LED light reflector. Moreover, in the above patent literature 2, although heat resistance of these liquid crystalline polyester resin is superior, there is a following problem that an initial reflectance ratio is low.

Further, in the above patent literature, although these epoxide resin has a superior initial reflectance and a superior heat resistance, there is following problems that a stability for storage is low, a posttreatment after molding is difficult, it is needed to make a tablet of the resin composition because of production by transfer molding, and since it is relatively high cost, in the above patent literature 7, it is not widely used for a general LED light reflector and a general surface-mount-type light-emitting device. Moreover, although an LED light reflector made by semiaromatic polyamide resin in the above patent literature 4, and a surface-mount-type light-emitting device made by semiaromatic polyamide resin in the above patent literature 8 can be produced by injection molding to give a superior productivity, there is a problem that a lowering brightness of LED lamp occurs since it is impossible to maintain an initial reflectance because of a low heat discoloration resistance.

Moreover, in the above patent literatures 5 and 9, although an initial reflectance of an unsaturated polyester resin is favorable, but there are a few problems that a granulatability and a dimensional stability in storage are inferior.

Moreover, in the above patent literatures 5 and 9, an amorphous unsaturated polyester resin composition has some problems that (A) since a dimensional stability in storage in a temperature range of 30°C or more is bad, this makes it possible to induce a shape variation and anastomosis of resin composition such as blocking, (B) during a manufacture of resin composition or a molding of LED reflector, a contamination of metal powder in the resin composition by ablation of a manufacture instrument thereby reducing an initial reflectance , (C) since a flowability of resin composition is reduced, moldability becomes worse, etc., there are above problems (A) to (C), there are a few remaining problems which much needs to be improved in. At this moment, a summary as to the problems in the case of the use of an amorphous unsaturated polyester resin composition.

That is, the amorphous unsaturated polyester resin comprising the amorphous unsaturated polyester and a liquid state of a copolymerizable monomer in a room temperature is liquid state in a room temperature. The amorphous unsaturated polyester resin for an LED reflector wherein a liquid state of the amorphous unsaturated polyester resin containing a white pigment and an inorganic filler , has a poor dimensional stability in storage and gives significant poor workability as often happen with BMC (bulk molding compound).

In order to give a dimensional stability in storage to the amorphous unsaturated polyester composition for an LED reflector, the amorphous unsaturated polyester resin for an LED reflector comprising the amorphous unsaturated polyester and a solid state of copolymerizable prepolymer in a room temperature is used to maintain a workability in a room temperature.

However, since the amorphous unsaturated polyester resin for an LED reflector comprising the amorphous unsaturated polyester and a solid state of copolymerizable prepolymer in a room temperature becomes a high degree of viscosity in a region of plasticizing temperature of a resin composition during molding of an LED reflector, in order to restrain an increase of degree of viscosity of a resin composition, a large particle diameter of a white pigment and an inorganic filler has to use.

Further, since the LED reflector comprising the amorphous unsaturated polyester resin composition for an LED reflector comprising the amorphous unsaturated polyester and a solid state of copolymerizable prepolymer in a room temperature uses a large particle diameter of a white pigment and an inorganic filler, a surface area of the white pigment and the inorganic filler is narrow, a reflecting surface area at the interface between the amorphous unsaturated polyester resin and both of the white pigment and the inorganic filler is narrow.
As a result of this, although it is possible to obtain a targeted initial reflectance by means of the use of a large amount of the white pigment, it has problems that a lot of an expensive white pigment must be used.

Further, since the amorphous unsaturated polyester resin comprising the amorphous unsaturated polyester and a solid state of copolymerizable prepolymer in a room temperature has a high degree of viscosity during melting of resin, it is impossible to fill up the white pigment and the inorganic filler having a superior heat resistance. That is, since there are a lot of amount of an organic resin which is oxidized and discolored by heat, it has problems that it is impossible to reach a targeted quality since reflectance is low after test for heat resistance. If an unsaturated polyester resin having a low degree of viscosity can be obtained, small particle diameter of the white pigment and the inorganic filler can be used, and it is thought that a reflectance can be improved. Furthermore, it is expected that the use of the unsaturated polyester resin having a melting point makes it possible to improve a dimensional stability in storage of a resin composition (change of configuration of a resin composition or a fusion bonding of each particle) in a temperature less than a melting point. However, a resin composition capable of using a small particle diameter of a white pigment and an inorganic filler wherein it has a superior heat resistance and a dimensional stability in storage etc., is not known up to now.

Therefore, it is an object of the present invention to use a crystalline unsaturated polyester resin as an unsaturated polyester resin and to solve problems shown in the case of the use of an amorphous unsaturated polyester resin and to provide a crystalline unsaturated polyester resin having an improved flowability during formulation of an inorganic filler and a white pigment etc.

There were problems that in a general unsaturated polyester resin composition, a cure shrinkage or a heat shrinkage during molding makes it possible to generate a minute concavity and convexity of the surface and to makes it easy to render a poor surface brilliance. In particular, this problem is serious in the unsaturated polyester resin composition for the LED reflector which a high reflectance and a high surface brilliance are required.

Although in a general unsaturated polyester resin composition for the LED reflector, in order to make a shrinkage small during molding, a formulation of a large amount of filler is need, but if a large amount of filler is formulated, there were a few problems that (a) a contamination of a metal powder made by abrasion of a manufacturing machine during a manufacture of the resin composition or a molding of the LED reflector into the resin composition makes it possible to reduce an initial reflectance, (b) a moldability becomes worse since a flowability of the resin composition comes down, etc.

Therefore, it is another object of the present invention to provide an unsaturated polyester resin composition wherein a low shrinkage and image clarity of a molded article, and further a granulatability of a resin composition are superior.

Moreover, although in the above patent literature 5, productivity is improved since an unsaturated polyester resin is molded by injection molding, it is not considered as to an effect for a quality of a molded article such as a viscosity, a cure rate, a moldability, or surface smoothness etc.

Therefore, it is another object of the present invention to provide a radical polymerizable resin composition for LED reflector wherein it is not easy to generate inferior goods during molding such as a flash, a shortage of filling.

It is another object of the present invention to solve a problem shown in the case of the use of an amorphous unsaturated polyester resin in the prior art to provide a longer operating life of a surface-mount-type light-emitting device.

### Means of solving the problems

The present inventors made strenuous studies on the case of the use of an unsaturated polyester resin to a resin composition for LED reflector from a viewpoint of various perspectives. As a result, the inventors discovered a new crystalline unsaturated polyester resin composition.

That is, a crystalline unsaturated polyester resin composition for an LED reflector according to the present invention comprises at least a crystalline unsaturated polyester resin and an inorganic filler, and is characterized in that the crystalline unsaturated polyester resin comprises a crystalline unsaturated polyester and a copolymerizable monomer and/or a copolymerizable prepolymer and the crystalline unsaturated polyester resin composition contains a white pigment.

Furthermore, in a preferred embodiment of the above mentioned crystalline unsaturated polyester resin composition for an LED reflector according to the present invention, it is characterized in that the crystalline unsaturated polyester resin is a solid state in a temperature range of 50°C or less.

Furthermore, in a preferred embodiment of the above mentioned crystalline unsaturated polyester resin composition for an LED reflector according to the present invention, it is characterized in that the crystalline unsaturated polyester resin comprises 40 to 95 part by weight of a crystalline unsaturated polyester, 60 to 5 part by weight of a copolymerizable monomer and/or a copolymerizable prepolymer.

Furthermore, in a preferred embodiment of the above mentioned crystalline unsaturated polyester resin composition for an LED reflector according to the present invention, it is characterized in that the copolymerizable monomer of a liquid state at a room temperature is 50 percent by weight or more for total amount of a copolymerizable monomer and/or a copolymerizable prepolymer.

Furthermore, in a preferred embodiment of the above mentioned crystalline unsaturated polyester resin composition for an LED reflector according to the present invention, it is characterized in that the crystalline unsaturated polyester resin is 10 to 35 percent by weight for total amount of composition, total amount of an inorganic filler and a white pigment is 50 to 80 percent by weight for total amount of composition, a ratio of the white pigment in total amount of the inorganic filler and the white pigment is 10 to 50 percent by weight.

Furthermore, in a preferred embodiment of the above mentioned crystalline unsaturated polyester resin composition for an LED reflector according to the present invention, it is characterized in that a ratio of the white pigment in total amount of the inorganic filler and the white pigment is 10 to 29 percent by weight.

Furthermore, in a preferred embodiment of the above mentioned crystalline unsaturated polyester resin composition for an LED reflector according to the present invention, it is characterized in that the white pigment is at least one or more selected from a group of titanium oxide, barium titanate, barium sulfate, zinc oxide, zinc sulfide.

Furthermore, in a preferred embodiment of the above mentioned crystalline unsaturated polyester resin composition for an LED reflector according to the present invention, it is characterized in that the average particle diameter of the white pigment is 2.0 µm or less.

Furthermore, in a preferred embodiment of the above mentioned crystalline unsaturated polyester resin composition for an LED reflector according to the present invention, it is characterized in that the average particle diameter of the inorganic filler is within a range from 0.1 to 50 µm.

Furthermore, a granular material according to the present invention, it is characterized in that the granular material comprises the crystalline unsaturated polyester resin composition for an LED reflector according to the present invention.

Furthermore, an LED reflector according to the present invention is characterized by molding the granular material comprising the crystalline unsaturated polyester resin composition for an LED reflector according to the present invention.

Furthermore, the present inventors made strenuous studies on the case of the use of an unsaturated polyester resin to a resin composition for LED reflector from a viewpoint of various perspectives. As a result, the inventors discovered a new unsaturated polyester resin composition.

That is, an unsaturated polyester resin composition for an LED reflector according to the present invention, wherein the unsaturated polyester resin composition for an LED reflector comprises at least an unsaturated polyester resin and an inorganic filler, and is characterized in that the unsaturated polyester resin comprises an unsaturated polyester, a copolymerizable monomer and/or a copolymerizable prepolymer and a thermoplastic resin, and the unsaturated polyester resin composition contains a white pigment.

Furthermore, in a preferred embodiment of the above mentioned unsaturated polyester resin composition for an LED reflector according to the present invention, it is characterized in that the unsaturated polyester resin comprises 99 to 55 part by weight of total amount of the unsaturated polyester and a copolymerizable monomer and/or a copolymerizable prepolymer, and 1 to 50 part by weight of the thermoplastic resin.

Furthermore, in a preferred embodiment of the above mentioned unsaturated polyester resin composition for an LED reflector according to the present invention, it is characterized in that the unsaturated polyester resin is 10 to 35 percent by weight for total amount of composition, total amount of an inorganic filler and a white pigment is 50 to 80 percent by weight for total amount of composition, a ratio of the white pigment in total amount of the inorganic filler and the white pigment is 10 to 50 percent by weight.

Moreover, in a preferred embodiment of the above mentioned unsaturated polyester resin composition for an LED reflector according to the present invention, it is characterized in that the unsaturated polyester resin comprises at least crystalline unsaturated polyester resin.

Moreover, in a preferred embodiment of the above mentioned unsaturated polyester resin composition for an LED reflector according to the present invention, it is characterized in that the unsaturated polyester resin is a solid state in a temperature range of 50°C or less.

Moreover, in a preferred embodiment of the above mentioned unsaturated polyester resin composition for an LED reflector according to the present invention, it is characterized in that a copolymerizable monomer of a liquid state at a room temperature is 50 percent by weight or more for total amount of a copolymerizable monomer and/or a copolymerizable prepolymer.

Moreover, in a preferred embodiment of the above mentioned unsaturated polyester resin composition for an LED reflector according to the present invention, it is characterized in that a ratio of the white pigment in total amount of formulation amount of the inorganic filler and the white pigment is 10 to 29 percent by weight.

Moreover, in a preferred embodiment of the above mentioned unsaturated polyester resin composition for an LED reflector according to the present invention, it is characterized in that the white pigment is at least one or more selected from a group of titanium oxide, barium titanate, barium sulfate, zinc oxide, zinc sulfide.

Moreover, in a preferred embodiment of the above mentioned unsaturated polyester resin composition for an LED reflector according to the present invention, it is characterized in that the average particle diameter of the white pigment is 2.0 µm or less.

Moreover, in a preferred embodiment of the above mentioned unsaturated polyester resin composition for an LED reflector according to the present invention, it is characterized in that the average particle diameter of the inorganic filler is within a range from 0.1 to 50 µm.

Moreover, in a preferred embodiment of the above mentioned unsaturated polyester resin composition for an LED reflector according to the present invention, it is characterized in that a thermoplastic resin is selected from a group consisting of polymethyl methacrylate, polystyrene, acrylonitrile butadiene styrene, polyethylene, polypropylene, polyvinyl acetate, styrene-butadiene rubber and copolymer thereof.

Moreover, a granular material according to the present invention is characterized by comprising the unsaturated polyester resin composition for a LED reflector according to the present invention.

Moreover, an LED reflector according to the present invention is characterized in that it is produced by molding the granular material comprising the unsaturated polyester resin composition for a LED reflector according to the present invention.

Furthermore, the present inventors made strenuous studies on the case of the use of a resin composition for LED reflector from a viewpoint of various perspectives. As a result, the inventors discovered a new radical polymerizable resin composition.

A radical polymerizable resin composition for LED reflector according to the present invention is characterized in that the radical polymerizable resin composition for LED reflector comprises at least a radical polymerizable resin, an inorganic filler, a white pigment, wherein a degree of viscosity of the radical polymerizable resin composition is in a range from 0.1 to 100 kPa-s.

Moreover, in a preferred embodiment of the above mentioned radical polymerizable resin composition for an LED reflector according to the present invention, it is characterized in that a degree of viscosity of the radical polymerizable resin composition is in a range from 0.1 to 100kPa-s in a temperature range from 70 to 120°C.

Moreover, in a preferred embodiment of the above mentioned radical polymerizable resin composition for an LED reflector according to the present invention, it is characterized in that the radical polymerizable resin composition contains an unsaturated polyester resin.

Moreover, in a preferred embodiment of the above mentioned radical polymerizable resin composition for an LED reflector according to the present invention, it is characterized in that the radical polymerizable resin composition contains a crystalline unsaturated polyester resin.

Moreover, in a preferred embodiment of the above mentioned radical polymerizable resin composition for an LED reflector according to the present invention, it is characterized in that in the radical polymerizable resin composition, a gel time in a temperature range from 140 to 180°C is in a range of 5 to 120 sec.

Moreover, a granular material according to the present invention is characterized by comprising the radical polymerizable resin composition for LED reflector according to the present invention.

Moreover, an injection molding process according to the present invention is characterized by thermo-setting a granular material comprising the radical polymerizable resin composition for LED reflector according to the present invention at 140 to 180 °C.

Moreover, an LED reflector according to the present invention is characterized by obtaining by the injection molding process according to the present invention.

Furthermore, the present inventors made strenuous studies on the case of the use of a reflector produced by molding an unsaturated polyester resin composition from a viewpoint of various perspectives. As a result, the inventors discovered a new surface-mount-type light-emitting device according to the present invention.

That is, a surface-mount-type light-emitting device with an LED reflector according to the present invention is characterized in that it is made by molding an unsaturated polyester resin composition comprising at least an unsaturated polyester resin and an inorganic filler, and the unsaturated polyester resin comprises one or more selected from (A) an unsaturated polyester resin comprising an the crystalline unsaturated polyester, a copolymerizable monomer and/or a copolymerizable prepolymer, or (B) an unsaturated polyester resin comprising an unsaturated polyester, a copolymerizable monomer and/or a copolymerizable prepolymer, and the unsaturated polyester resin composition contains a white pigment.

Moreover, in a preferred embodiment of the above mentioned surface-mount-type light-emitting device according to the present invention, it is characterized in that the unsaturated polyester resin (A) comprises 40 to 95 part by weight of a crystalline unsaturated polyester, 60 to 5 part by weight of a copolymerizable monomer and/or a copolymerizable prepolymer.

Moreover, in a preferred embodiment of the above mentioned surface-mount-type light-emitting device according to the present invention, it is characterized in that the unsaturated polyester resin (B) comprises 99 to 50 part by weight of the mixture comprising 35 to 95 part by weight of unsaturated polyester and 60 to 5 part by weight of a copolymerizable monomer and/or a copolymerizable prepolymer, and 1 to 50 part by weight of the thermoplastic resin.

Moreover, in a preferred embodiment of the above mentioned surface-mount-type light-emitting device according to the present invention, it is characterized in that the unsaturated polyester resin (A) and/or (B) is 10 to 35 percent by weight for total amount of composition, total amount of the inorganic filler and the white pigment is 50 to 80 percent by weight for total amount of composition, and a ratio of the white pigment in total amount of the inorganic filler and the white pigment is 10 to 50 percent by weight.

Moreover, in a preferred embodiment of the above mentioned surface-mount-type light-emitting device according to the present invention, it is characterized in that the unsaturated polyester resin (A) and/or (B) is a solid state in a temperature range of 50°C or less.

Moreover, in a preferred embodiment of the above mentioned surface-mount-type light-emitting device according to the present invention, it is characterized in that the unsaturated polyester resin (B) contains at least a crystalline unsaturated polyester.

Moreover, in a preferred embodiment of the above mentioned surface-mount-type light-emitting device according to the present invention, it is characterized in that the device contains the molded article comprising the unsaturated polyester resin composition wherein the copolymerizable monomer of a liquid state at a room temperature is 50 percent by weight or more for total amount of the copolymerizable monomer and/or the copolymerizable prepolymer.

Moreover, in a preferred embodiment of the above mentioned surface-mount-type light-emitting device according to the present invention, it is characterized in that a ratio of the white pigment in total amount of the inorganic filler and the white pigment is 10 to 29 percent by weight.

Moreover, in a preferred embodiment of the above mentioned surface-mount-type light-emitting device according to the present invention, it is characterized in that the white pigment is at least one or more selected from a group of titanium oxide, barium titanate, barium sulfate, zinc oxide, zinc sulfide.

Moreover, a lighting device according to the present invention is characterized in that the lighting device is equipped with a surface-mount-type light-emitting device according to the present invention.

Moreover, an image display device according to the present invention is characterized in that the image display device is equipped with a surface-mount-type light-emitting device according to the present invention.

### Effect of Invention

A crystalline unsaturated polyester resin composition for an LED reflector according to the present invention has an advantage effect that the use of the crystalline unsaturated polyester resin composition as an unsaturated polyester resin makes it possible to render a flowability at a temperature of a melting point or more of the crystalline unsaturated polyester resin and to render a low viscosity of a resin composition if a small particle diameter of the white pigment and the inorganic filler is formulated, and even if it is the case that a formulation ratio of the white pigment in the total amount of both the inorganic filler and white pigment is low, it has an excellent performance on an initial reflectance of reflector and on a reflectance after a test for heat resistance, since a small particle diameter of the white pigment and the inorganic filler is formulated. Moreover, a resin composition according to the present invention has an advantage effect that it can obtain a high initial reflectance ratio because there are no contaminations such as a metal powder by an abrasion of a manufacture equipment during the preparation of formulation for the inorganic filler and the white pigment or the production of an LED reflector, and further it has a superior moldability and a dimensional stability in storage since it is possible to maintain a solid state at a temperature range from a room temperature or more to 50 °C or less.

That is, the composition according to the present invention has an advantage effect that it is possible to provide an LED reflector having a high early reflectance, a superior heat resistance and a high reflectance after a test for a heat resistance.

Moreover, an LED lamp comprising a crystalline unsaturated polyester resin composition according to the present invention has a long life and can provide a LED reflector having a superior reflectance at a low cost.

Moreover, an unsaturated polyester resin composition for an LED reflector according to the present invention has an advantage effect that the use of the unsaturated polyester resin containing a thermoplastic resin makes it possible to provide a LED reflector having a low shrinkage and a superior image clarity without a large formulation amount of a filler even if an amorphous unsaturated polyester is used. Furthermore, an unsaturated polyester resin composition for an LED reflector according to the present invention has an advantage effect that the use of the crystalline unsaturated polyester makes it possible to render a superior an initial reflectance of reflector and a superior reflectance after a test for a heat resistance since a small particle diameter of the white pigment and the inorganic filler can be formulated. Moreover, a resin composition according to the present invention has an advantage effect that it can obtain a high initial reflectance because there are no contaminations such as a metal powder by an abrasion of a manufacture equipment during the preparation of formulation for the inorganic filler and the white pigment or the production of an LED reflector, and further it has a superior formability and a dimensional stability in storage since it is possible to maintain a solid state at a temperature range from a room temperature or more to 50 °C or less.

That is, the composition according to the present invention has advantage effects that it is possible to provide an LED reflector having a superior performance such as a low shrinkage of a molded article, an image clarity, further a granulatability of a resin composition.

Moreover, an LED lamp comprising an unsaturated polyester resin composition according to the present invention has a long life and can provide a LED reflector having a superior performance such as a reflectance, a low shrinkage and an image clarity at a low cost.

Moreover, a radical polymerizable resin composition for an LED reflector according to the present invention has an advantage effect that it is possible to obtain a radical polymerizable resin composition for an injection molding in order to obtain a LED reflector wherein it is difficult to generate a defect of molding such as a flash and a shortage of filling, and it has a superior productivity, reflectance and a superior surface brilliancy.

An aspect of an unsaturated polyester resin composition molded to a reflector which is equipped with a surface-mount-type light-emitting device according to the present invention has an advantage effect that the use of the crystalline unsaturated polyester makes it possible to use the formulation of a small particle diameter of the white pigment and the inorganic filler and thereby rendering a superior initial reflectance of the reflector and a reflectance after a test of heat resistance. Moreover, an unsaturated polyester resin composition molded to a reflector which is equipped with a surface-mount-type light-emitting device according to the present invention has an advantage effect that it can obtain a high initial reflectance because there are no contaminations such as a metal powder by an abrasion of a manufacture equipment during the preparation of formulation for the inorganic filler and the white pigment or the production of an LED reflector, and further it has a superior formability and a stability of storage and configuration since it is possible to maintain a solid state at a temperature range from a room temperature or more to 50 °C or less.

Another aspect of an unsaturated polyester resin composition molded to a reflector which is equipped with a surface-mount-type light-emitting device according to the present invention has an advantage effect that since it can contain a thermoplastic resin, it is possible to provide a LED reflector having a low shrinkage and a superior image clarity without a large formulation amount of a filler even if an amorphous unsaturated polyester is used.

Therefore, a surface-mount-type light-emitting device according to the present invention equipped with a reflector to which these unsaturated polyester resin composition is molded, has an advantage effect that it is possible to render a superior initial performance such as a reflectance and maintain an initial performance over a long period.

Further, a lighting device equipped with a surface-mount-type light-emitting device according to the present invention equipped with a reflector to which these unsaturated polyester resin composition is molded, has an advantage effect that it is possible to render a superior initial performance and a long life.

Further, an image display equipped with a surface-mount-type light-emitting device according to the present invention equipped with a reflector to which these unsaturated polyester resin composition is molded, has an advantage effect that it is possible to render a superior initial performance and a long life.

### Brief Description of the Drawings

[Figure 1] Fig. 1 gives a graph showing change with time of a reflectance (wavelength: 450nm) when a test piece for measuring a reflectance is maintained in an air forced oven at 150 °C. (Example 15)
[Figure 2] Fig. 2 gives a pattern diagram as an example of a constitution of a light-emitting device 1 according to an embodiment of the present invention.
[Figure 3] Fig. 3 gives a pattern diagram as an example of a constitution of a light-emitting device 2 according to an embodiment of the present invention.
[Figure 4] Fig. 4 gives a graph showing a change with time of a reflectance (wavelength: 450nm) when a test piece for measuring a reflectance is maintained in an air forced oven at 150 °C. (Example 1)

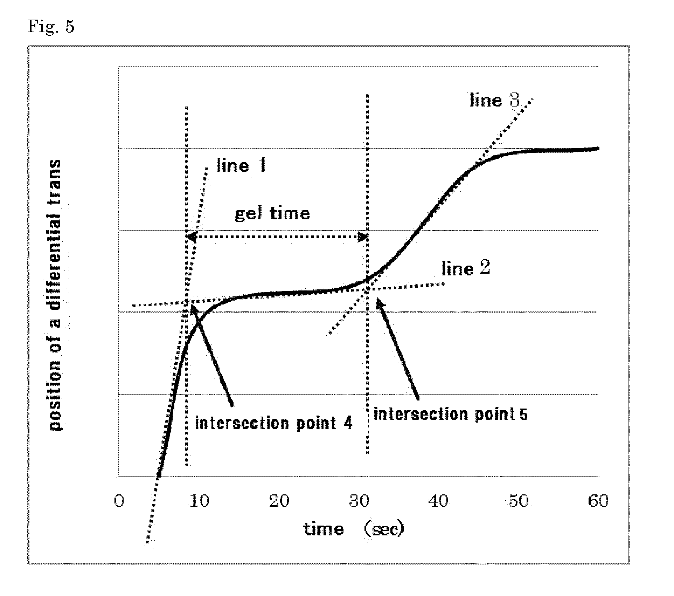

[Figure 5] Fig. 5 gives a figure showing a relationship between a differential transformer position and time, in order to measure a gel time. A resin composition is set on a central portion of an under mold of a press die with a differential transformer type position sensor at the under mold (flexible side) thereof, and then immediately a die is raised up to clamp a mold, a relationship between a differential transformer position and time at the time of a molding under heat and presser is shown. A line 1 corresponds to a mold clamping speed. The more a resin composition in a die flows, the more a movement of a differential transformer becomes late, and a differential transformer stops once at a time that it becomes a constant thickness. However, since a thermo-setting shrinkage begins according to the progress of thermo-setting, a position of the differential transformer starts moving upward. A line of tangency on a point of inflection of an S-curve obtained at this stage is line 2. If the thermo-setting terminated, the position of a differential transformer becomes constant. A line of tangency on a point of inflection of an S-curve obtained at this stage is line 3. A time from an intersection point 4 of line 1 and line 2 to an intersection point 5 of line 2 and line 3 was defined as a gel time.

### Mode for Carrying Out the Invention

A crystalline unsaturated polyester resin composition for an LED reflector according to the present invention comprises at least a crystalline unsaturated polyester resin and an inorganic filler, and is characterized in that the crystalline unsaturated polyester resin comprises a crystalline unsaturated polyester and a copolymerizable monomer and/or a copolymerizable prepolymer and the crystalline unsaturated polyester resin composition contains a white pigment. Moreover, in the present specification, a crystalline unsaturated polyester resin composition for an LED reflector is also called a crystalline unsaturated polyester resin composition.

Although a crystalline unsaturated polyester resin composition according to the present invention is characterized in that it comprises a crystalline unsaturated polyester resin composition, this is because that the present inventors made strenuous studies on the above mentioned problems on the resin composition for an LED reflector by using an unsaturated polyester resin from a viewpoint of various perspectives, and as a result, the inventors discovered that the above problems is easy to occur in the case of the use of an amorphous unsaturated polyester resin.

It is possible to obtain a crystalline unsaturated polyester resin according to the present invention by mixing a crystalline unsaturated polyester, and a copolymerizable monomer and/or a copolymerizable prepolymer etc. Although a copolymerizable monomer and/or a copolymerizable prepolymer is generally mixed to a resin together with other mixture during a preparation of a resin composition, before the preparation of a resin composition it may mix with a resin.

At this moment, the explanation of a crystalline and an amorphous unsaturated polyester resin is as follows. There are two type of an unsaturated polyester resin, that is, an amorphous unsaturated polyester resin and a crystalline unsaturated polyester resin, an amorphous unsaturated polyester resin is general which is solved in a copolymerizable monomer such as a styrene monomer.

As an unsaturated polyester resin composition capable of being molded by an injection molding and using a general copolymerizable monomer such as a styrene monomer, a wet type of BMC at a room temperature is known. The BMC uses an unsaturated polyester resin, and there are some problems such as (a) an ancillary facility such as a plunger for pressing into a molding machine is needed, (b) a handleability is poor since it is blocky, and a workability is poor since it is formless, (c) a storage stability is poor since it is wet type.

A solid type of an amorphous unsaturated polyester resin composition at room temperature is solved the above problems (a) to (c) by using the amorphous unsaturated polyester with a solid state of a copolymerizable monomer at room temperature, a copolymerizable prepolymer and a liquid state of a copolymerizable monomer in a usable range. On the other hand, it is possible to combine a crystalline unsaturated polyester resin composition and a liquid state or a solid state of a copolymerizable monomer and a copolymerizable prepolymer at a room temperature in a given range, and the present inventors focused that there are no restriction of the combination of a crystalline unsaturated polyester, a copolymerizable monomer, and a copolymerizable prepolymer.

The present invention has a high initial reflectance, a high heat resistance and a high reflectance after a test for heat resistance even if it is a small amount of a white pigment as mentioned below, since it is a crystalline unsaturated polyester resin composition for an LED reflector comprises a crystalline unsaturated polyester resin using a different type of an unsaturated polyester resin comparing with an unsaturated polyester resin in the above patent literature 5.

Explanation of the differences between an amorphous unsaturated polyester used in the prior art and a crystalline unsaturated polyester is as follows. That is, a crystalline unsaturated polyester resin comprising a crystalline unsaturated polyester and a liquid state of a copolymerizable monomer at a room temperature is a solid state at a room temperature and is a liquid state and a low viscosity at a melting point or more of a crystalline unsaturated polyester resin. On the other hand, as mentioned before, an amorphous unsaturated polyester resin comprising an amorphous unsaturated polyester and a liquid state of a copolymerizable monomer at a room temperature is a liquid state at a room temperature. The major differences of this aspect, as it will be clear from the example mentioned below, make is possible to give quite a lot of some advantage effects such as an initial reflectance, a heat resistance and a dimensional stability in storage to a resin composition, a granular material as well as an LED reflector.

A crystalline unsaturated polyester resin composition for an LED reflector using a crystalline unsaturated polyester resin formulated with a white pigment and an inorganic filler has a dimensional stability in storage in a temperature range less than a melting point and maintains workability thereof.

From this property of a crystalline unsaturated polyester, the present inventors found the following some advantages in the case of using it to an LED reflector. That is, the crystalline unsaturated polyester resin makes it possible to use a small particle diameter of a white pigment and an inorganic filler capable of making a viscosity of a resin composition becomes high, since it becomes a low viscosity in a temperature region which a resin composition plasticizes when molding an LED reflector.

An LED reflector comprising a crystalline unsaturated polyester resin composition for an LED reflector has a white pigment and an inorganic filler with a wide surface area, and a wide reflecting area on the interface between a crystalline unsaturated polyester resin, and the white pigment and inorganic filler, since it uses a small particle diameter of a white pigment and an inorganic filler.
As a result of this, even if the ratio of the use of the white pigment is small, it is possible to attain a targeted initial reflectance.

Further, a crystalline unsaturated polyester resin comprising a crystalline unsaturated polyester resin, a liquid state of a copolymerizable monomer at a room temperature, and a copolymerizable prepolymer in a range keeping features such as reflectance, a heat discoloration resistance makes it possible to fill a white pigment and an inorganic filler with a superior heat resistance up highly since it is a low viscosity during melting of resin. That is, it is possible to attain a targeted high reflectance after a test for heat resistance since it is possible to reduce a content of a resin of organic material which is oxidized and discolored by heat.

Furthermore, in a preferred embodiment of the above mentioned crystalline unsaturated polyester resin composition for an LED reflector according to the present invention, it is characterized in that the crystalline unsaturated polyester resin is a solid state in a temperature range of 50°C or less, form a viewpoint of a dimensional stability in a handleability and a workability. That is, it is possible to carry out a grinding process and an extruded pellet process since it is a solid state in storage temperature range from a room temperature of more to 50°C or less.

Furthermore, the crystalline unsaturated polyester resin composition for an LED reflector according to the present invention can contain an amorphous unsaturated polyester in a range keeping features such as a dimensional stability in storage.

Furthermore, in a preferred embodiment of the above mentioned crystalline unsaturated polyester resin composition for an LED reflector according to the present invention, it is characterized in that the crystalline unsaturated polyester resin comprises 40 to 95 part by weight of a crystalline unsaturated polyester, 60 to 5 part by weight of a copolymerizable monomer and/or a copolymerizable prepolymer. It is preferable that the crystalline unsaturated polyester resin is formulated by a ratio of 50 to 95 part by weight of a crystalline unsaturated polyester, 50 to 5 part by weight of a copolymerizable monomer and/or a copolymerizable prepolymer. The reason why the above range is set is because in the case that an amount of a copolymerizable monomer and/or a copolymerizable prepolymer formulated to the crystalline unsaturated polyester is larger than the above range, there is possibility that it is impossible to carry out a grinding process or an extruded pellet process and thereby reducing a handleability considerably, and in the case that an amount of a copolymerizable monomer and/or a copolymerizable prepolymer is smaller than the above range, there is possibility that a hardening property reduces and thereby it being difficult to obtain a reflector having a good appearance.

Furthermore, in a preferred embodiment of the above mentioned crystalline unsaturated polyester resin composition for an LED reflector according to the present invention, it is characterized in that the copolymerizable monomer of a liquid state at a room temperature is 50 percent by weight or more for total amount of a copolymerizable monomer and/or a copolymerizable prepolymer. The use of the crystalline unsaturated polyester resin makes it possible to give advantage effects that a solid state of crystalline unsaturated polyester resin composition in a temperature range of 50°C or less can be obtained even if the copolymerizable monomer of a liquid state at a room temperature is used in 50 percent by weight or more for total amount of a copolymerizable monomer and/or a copolymerizable prepolymer.

Furthermore, in a preferred embodiment of the above mentioned crystalline unsaturated polyester resin composition for an LED reflector according to the present invention, from a viewpoint of a flowability and a heat resistance, the crystalline unsaturated polyester resin is 10 to 35 percent by weight for total amount of composition, total amount of an inorganic filler and a white pigment is 50 to 80 percent by weight for total amount of composition. Further, from a viewpoint of reflectance, in a preferred embodiment, it is characterized in that a ratio of the white pigment in total amount of the inorganic filler and the white pigment is 10 to 50 percent by weight. A ratio of the white pigment in total amount of the inorganic filler and the white pigment is preferably 10 to 29 percent by weight.

The crystalline unsaturated polyester resin is preferably 10 to 35 percent by weight for total amount of composition. This is because there is possibility that a flowability reduces and mldability becomes worse in the case that it is less than 10 percent by weight, and there is possibility that a heat resistance reduces in the case that it is 35 percent by weight or more.

The crystalline unsaturated polyester resin according to the present invention is no compatibility with acetone, styrene monomer etc., at a room temperature and it comprises a mixture formulated with a crystalline unsaturated polyester and a copolymerizable monomer and/or a copolymerizable prepolymer, and it is a solid state of crystalline unsaturated polyester resin at a room temperature. It's property is that the crystalline unsaturated polyester does not solve if acetone, styrene monomer etc., is added to the crystalline unsaturated polyester at a room temperature. On the other hand, the amorphous unsaturated polyester is compatibility with acetone, styrene monomer etc., and it's property is that it becomes liquid state if acetone, styrene monomer etc., is added to the amorphous unsaturated polyester, a mixture of the amorphous unsaturated polyester and a copolymerizable monomer and/or a copolymerizable polymer is a liquid state of resin.

An unsaturated polyester is obtained by reacting with an unsaturated polybasic acid, a saturated polybasic acid and glycols according to a known dehydration condensation reaction, and thereby having an acid value of 5 to 40 mg-KOH/g generally.
It is possible to obtain an unsaturated polyester having a crystallinity by selecting an acid component or a combination of an unsaturated polybasic acid, a saturated polybasic acid, and selecting or combining glycols, and selecting a ratio of formulation thereof accordingly in a manufacture of an unsaturated polyester.

As an unsaturated polybasic acid, mention may be made of maleic acid, maleic anhydride, fumaric acid, citraconic acid, mesaconic acid, itaconic acid, tetrahydrophthalic acid, tetrahydrophthalic anhydride, methyltetrahydrophthalic anhydride, glutaconic acid etc.

As a saturated polybasic acid, mention may be made of phthalic acid, phthalic anhydride, isophthalic acid, terephthalic acid, succinic acid, adipic acid, sebacic acid, azelaic acid, tetrahydrophthalic anhydride, methyltetrahydrophthalic anhydride, endo methylene - tetra - hydro phthalic anhydride, HET acid, tetrabromophthalic anhydride etc.

As glycols, mention may be made of ethylene glycol, 1,3 - propanediol, 1,4 - butanediol, 1,5 - pentanediol, 1,6 - hexanediol, propylene glycol, diethylene glycol, triethylene glycol, dipropylene glycol, neopentyl glycol, 1,3 - butanediol, hydrogenated bisphenol-A, bisphenol-A propylene oxide adduct compound, cyclohexanedimethanol, dibromo neopentyl glycol, etc.

In the present invention, among a crystalline unsaturated polyester, a crystalline unsaturated polyester is preferable wherein fumaric acid is used as an unsaturated polybasic acid, isophthalic acid or terephthalic acid is used as a saturated polybasic acid, ethylene glycol, 1,3-propanediol, 1,4 - butanediol, 1,5 - pentanediol, 1,6 - hexanediol, cyclohexanedimethanol are used as a primary component of glycol.

As a copolymerizable monomer mixed with the crystalline unsaturated polyester according to the present invention, for example, mention may be made of vinyl aromatic compound such as styrene monomer, α-methylstyrene, vinyl toluene, α- chlorostyrene which have a vinyl group; vinyl ester such as vinyl acetate, vinyl propionate, vinyl lactate, vinyl butyrate, VeoVa monomer (Shell Chemicals Japan Ltd.); (meta) acrylic ester such as methyl acrylate, ethyl acrylate, n-butyl acrylate, methyl methacrylate, ethyl methacrylate, n-butyl methacrylate etc.

Moreover, it is possible to use a copolymerizable monomer with two functional or more such as triacyl cyanurate, diethylene glycol dimethacrylate, diallyl tetrabromo phthalate, phenoxyethyl acrylate, 2- hydroxyethyl acrylate, 1,6- hexanediol diacrylate etc. Further, it is possible to use a copolymerizable monomer with two functional or more which is a solid state at a room temperature, such as polyethyleneglycol di(meta)acrylate, ethoxylated isocyanuric acid triacrylate, pentaerythritol tetraacrylate etc. These copolymerizable monomer may be used by itself or by the combination of two or more thereof.

It is possible to use a liquid state of a copolymerizable monomer and a solid state of a copolymerizable monomer at a room temperature as a copolymerizable monomer. At that time, a copolymerizable monomer of a liquid state at a room temperature for total amount of a copolymerizable monomer and/or a copolymerizable prepolymer is preferably 50 percent by weight or more. The use of 50 percent by weight or more of a copolymerizable monomer of a liquid state at a room temperature for total amount of a copolymerizable monomer and/or a copolymerizable polymer makes it possible to pack a filler contained in a resin composition highly and thereby improving a heat resistance. A ratio of a copolymerizable monomer of a liquid state at a room temperature for total amount of a copolymerizable monomer and/or a copolymerizable prepolymer is preferably 70 percent by weight or more, more preferably 90 percent by weight or more. It is possible to use, in particular, styrene monomer, methyl methacrylate, diethylene glycol dimetaacrylate preferably. Since an amorphous unsaturated polyester resin composition comprising an amorphous unsaturated polyester and a copolymerizable monomer of a liquid state at a room temperature has a low drying property by set to the touch, there is a possibility that a workability and a dimensional stability in storage reduce. Moreover, it is possible to use a copolymerizable prepolymer in a range that does not impair a flowability during molding. It is possible to use a diallyl phthalate prepolymer etc., as a copolymerizable prepolymer.

It is possible to formulate an inorganic filler in the crystalline unsaturated polyester resin composition for an LED reflector according to the present invention. Although as an inorganic filler, mention may be made of calcium carbonate, magnesium carbonate, barium carbonate, calcium hydroxide, aluminum hydroxide, magnesium oxide, mica, silica, aluminum oxide, but from a viewpoint of reflectance, calcium carbonate, aluminum hydroxide among them is preferable. These are used by itself or two or more.

The average particle diameter of the inorganic filler is used within a range from 0.1 to 50 µm, preferably from 0.1 to 20 µm. The average particle diameter is measured by a median size or a measurement of a geometric average value according to a laser diffraction /scattering type of a device of measuring a particle size distribution. However, there are possibility that the average particle diameter is different according to the used method of calculating. The use of the inorganic filler having an average particle diameter makes it possible to obtain the crystalline unsaturated polyester resin for an LED reflector having a superior flowability for molding, a superior heat discoloration resistance and reflectance.

Furthermore, in a preferred embodiment of the above mentioned crystalline unsaturated polyester resin composition for an LED reflector according to the present invention, it is characterized in that the white pigment is at least one or more selected from a group of titanium oxide, barium titanate, barium sulfate, zinc oxide, zinc sulfide. In the present invention, among these white pigment, from a viewpoint of a reflectance, in particular, it is possible to use titanium oxide preferably.
As titanium oxide, for example, mention may be made of an anatase type of titanium oxide, a rutile type of titanium oxide, a brookite type of titanium oxide. Among them, a rutile type of titanium oxide having a superior heat stability can be preferably used. It is also possible to use any titanium oxide surface treated by a treating agent, as long as the objects of the present invention are not impaired.

Moreover, in a preferred embodiment of the above mentioned crystalline unsaturated polyester resin composition for an LED reflector according to the present invention, it is characterized in that the average particle diameter of the white pigment is 2.0 µm or less. Moreover, the average particle diameter of the white pigment is preferably 2.0 µm or less, more preferably from 0.01 to 1.0 µm, further more preferably from 0.1 to 0.5 µm from a viewpoint of a reflectance. The average particle diameter is calculated by a measurement of an initial particle using an electron microscope. Moreover, there is possibility that a superior moldability cannot be obtained and thereby it being impossible to obtain a high reflectance in the case that an average particle diameter of the white pigment is large.

In the crystalline unsaturated polyester resin composition for an LED reflector according to the present invention, a total amount of an inorganic filler and a white pigment is 50 to 80 percent by weight, and preferably 60 to 75 percent by weight for total amount of composition. This range of the formulation can make it possible to obtain the crystalline unsaturated polyester resin composition for an LED reflector having a superior moldability. The molding of the reflector using the crystalline unsaturated polyester resin composition make it possible to obtain an LED reflector having a superior heat discoloration resistance and a high reflectance.

Moreover, in a ratio of the white pigment in total amount of the inorganic filler and the white pigment, the amount of the white pigment can be from 10 to 50 percent by weight, and preferably from 10 to 29 percent by weight from a viewpoint of the reflectance and an abrasion of equipment. There is possibility that in the case that a ratio of the white pigment is too small, an initial reflectance of the reflector and a reflectance after a test of heat resistance becomes low, there is possibility that in the case that it is too much, contaminations such as a metal powder by an abrasion of a manufacture equipment during a manufacture of the resin composition or a production of an LED reflector and thereby reducing the initial reflectance.

In the crystalline unsaturated polyester resin composition for an LED reflector according to the present invention, a reinforcing material can be formulated. The use of the reinforcing material makes it possible to obtain an unsaturated polyester resin composition for an LED reflector having a superior strength characteristic, dimensional stability.

Although as a reinforcing material used for the present invention, glass fibers can be used which is used as a reinforcing material of an unsaturated polyester resin composition used for a fiber-reinforced plastic (FRP) such as a bulk molding compound (BMC), a sheet molding compounds (SMC), in general, it is not limited to glass fibers, but those other than the glass fibers can be also used. Although as a reinforcing material used for other than the glass fibers, mention may be made of carbon fibers, an inorganic fibers such as whiskers, an organic fibers such as aramid fibers or polypropylene fibers, aramid fibers or polypropylene fibers are preferable.

As glass fibers, mention may be made of glass fibers such as E glass (non - alkali glass fibers for electricity) wherein the raw material is silicate glass, borosilicate glass, C glass (alkali glass fibers for chemistry), A glass (acid-resistant glass), S glass (high-strength glass), those of continuous fibers (roving), discontinuous fibers (chopped strands) can be used. Further, those of the surface-treated these glass fibers can be also used.

Among them, from a viewpoint of a size and shape of molded articles, the use of the discontinuous fibers (chopped strands) are preferable. Moreover, in the case of a woven material or a nonwoven fabric, it is not suitable for the present invention because it is difficult to uniformly mix it with other resin composition, that is, the unsaturated polyester resin, the white pigment and the inorganic filler etc. Further, there is possibility that it is difficult to fill the composition to the end of minute and complicated molded articles since long glass fibers make flowability of a resin composition poor. In the case that an L/D (a ratio of a length of fiber for a diameter of fiber) is small, there is possibility that a stiffening effect as a reinforcing material is not attained. A preferable length of fiber of the reinforcing material used in the present invention is in a range from 1.5 to 13 mm, and a diameter of fiber is in a range from 6 to 15 µm.

Moreover, in a preferred embodiment of the unsaturated polyester resin composition for an LED reflector according to the present invention, the unsaturated polyester resin composition for an LED reflector is characterized by containing 3 to 20 percent by weight of one or more of the reinforcing material selected from a group consisting of glass fibers, aramid fibers, polypropylene fibers for the composition.

The crystalline unsaturated polyester resin composition for an LED reflector according to the present invention wherein the crystalline unsaturated polyester resin, an inorganic filler, a white pigment and a reinforcing material are formulated at preferably the above formulation amount, has a dimensional stability in storage at a temperature of 50 °C or less and a superior workability.

In the crystalline unsaturated polyester resin composition for an LED reflector according to the present invention, it is possible to use a thermolysis type of an organic peroxide as a polymerization initiator or a polymerization inhibitor which is generally used to the unsaturated polyester resin composition.

As an organic peroxide, mention may be made of t - butylperoxy - 2-ethylhexyl monocarbonate, 1,1-di(t-hexylperoxy) cyclohexane, 1,1-di(t-butylperoxy)- 3,3,5 - trimethyl cyclohexane, t - butyl peroxyoctoate, benzoyl peroxide, methyl ethyl ketone peroxide, acetylacetone peroxide, t - butylperoxy benzoate, dicumyl peroxide etc. These may be used by itself or by the combination of two or more thereof.

Among them, from a viewpoint of molding conditions, stability of storage, the use of organic peroxide wherein the 10 hours half-life temperature is 100 °C or more, is preferable, and specifically dicumyl peroxide can be used preferably.

As a polymerization inhibitor, mention may be made of quinones such as hydroquinone, monomethyl ether hydroquinone, toluhydroquinone, di - t - 4 - methylphenol, monomethyl ether hydroquinone, phenothiazine, t- buthyl catechol, parabenzoquinone, pyrogallol, a phenolic compound such as 2,6 - di - t - butyl - cresol, 2,2 - methylene - bis - (4 - methyl - 6 - t - butyl phenol), 1,1,3 - tris - (2-methyl - 4 - hydroxyl - 5 - t - butyl phenyl) butane etc. These may be used by itself or by the combination of two or more thereof.

Moreover, it is possible to formulate other inorganic filler appropriately to the unsaturated polyester resin composition for an LED reflector according to the present invention in a range keeping features such as a flowability of a resin composition or a reflectance when it is molded to an LED reflector.

As these type of other inorganic filler, mention may be made of an empty particle such as an oxide or hydrate thereof, an inorganic bubble particle, a silica balloon etc.

It is possible to use a release agent in the crystalline unsaturated polyester resin composition for an LED reflector according to the present invention. As a release agent, mention may be made of waxes such as fatty acid type, fatty acid metal salt type, mineral type etc., which is generally used for a thermosetting resin, in particular, it is possible to preferably use those of fatty acid type, fatty acid metal salt type of waxes which is superior for a heat resistance.

As these release agent, specifically mention may be made of stearic acid, zinc stearate, aluminum stearate, calcium stearate. These mold release agent may be used by itself or by the combination of two or more thereof.

These release agent can be formulated with 3 to 15 parts by weight for 100 parts by weight of the unsaturated polyester resin. This range of the formulated amount of the release agent makes it possible to keep a good property of mold release. In the case that it is too small, there is possibility that a property of mold release between a die and a molded article becomes low and thereby reducing a productivity extremely, and in the case that it is too much, there is possibility that a sealant cannot be attached firmly. Since there is no need to coat the release agent to the die by means of the formulation of the release agent to the composition in advance, it is possible to apply it to a molding method such as an injection molding wherein a molding cycle is short.

In the present invention, other than these components, according to need, it is possible to accordingly formulate a polymerization initiator and a polymerization inhibitor in order to control a curing condition of the unsaturated polyester resin composition, a colorant, a thickener, a light stabilizer, a processing stabilizer, an ultraviolet absorber, a nucleating agent, a fluorescent brightening agent, a fire retardant, a photopolymerization initiator, an antibacterial agent, an antistatic agent, a foaming agent, a surfactant, a surface modifier, a coupling agent, the other organic additive agent and inorganic additive agent.

The unsaturated polyester resin composition for an LED reflector according to the present invention can be manufactured by formulating each components to mix it adequately and uniformly by using a mixer, a blender and after that, to control and granulate by using a mixer, an extruder capable of applying heat and pressure. Since in the case that a glass woven fabric is used as a reinforcement, it is possible to mix and granulate adequately by using a mixer, an extruder, and in the case that nonwoven glass fabric is used, it is impossible to keep a shape of nonwoven fabric because a sheet type of nonwoven fabric is destroyed during mixture, it cannot find out a superiority of the use of woven fabric and nonwoven fabric.

Furthermore, a granular material according to the present invention is characterized in that the granular material comprises the crystalline unsaturated polyester resin composition for an LED reflector according to the present invention. The granular material comprising the crystalline unsaturated polyester resin composition for an LED reflector according to the present invention may be a fine particle obtained by pulverizing the composition or a pellet form.

Furthermore, an LED reflector according to the present invention is characterized by molding the granular material comprising the crystalline unsaturated polyester resin composition for an LED reflector according to the present invention. It is possible to mold the LED reflector by a various sort of a method of molding a thermosetting resin according to a common procedure.

Furthermore, a crystalline unsaturated polyester resin composition for an LED reflector according to the present invention is a dry type and a good heat stability during melting, it is possible to use preferably a melt-heat molding process such as an injection molding process, an injection compression molding process, transfer molding process etc. since in a laminated sheet using a glass woven fabric or a nonwoven glass fabric as a reinforcement, it is needed to impregnate the resin composition into a woven fabric or a nonwoven fabric in advance, the resin composition must be a liquid state, and therefore, it is different characteristic comparing with the unsaturated polyester resin composition according to the present invention. The molding process is limited to a pressure molding process using a press.

Among them, the injection molding process using an injection molding machine is preferably, the use of injection molding process makes it possible to further shorten a time for molding and to manufacture an LED reflector having a complicated shape.

Next, the unsaturated polyester resin composition for an LED reflector using a thermoplastic resin, and a granular material comprising the composition, and an LED reflector made by molding the granular material, will be explained as follows.

The unsaturated polyester resin composition for an LED reflector according to the present invention, wherein the unsaturated polyester resin composition for an LED reflector comprises at least an unsaturated polyester resin and an inorganic filler, and is characterized in that the unsaturated polyester resin comprises an unsaturated polyester, a copolymerizable monomer and/or a copolymerizable prepolymer and a thermoplastic resin, and the unsaturated polyester resin composition contains a white pigment.

In the present invention, as an unsaturated polyester resin, it is possible to use any unsaturated polyester resin without regard to crystal or amorphous. Moreover, the thermoplastic resin is generally a resin which can be molded by heating and softening without occurring reaction to have a plasticity, but can become solidified if it is cooled. In the case of the repeat of cooling and heating, it is a resin which the plasticity is reversibly maintained. In the present invention, it is possible to use such thermoplastic resin.

That is, in the present invention, as the thermoplastic resin, mention may be made of acrylonitrile butadiene stylene, polypropylene, polyethylene, polystyrene, polymethyl methacrylate, polyethylene terephthalate, polyethylene naphthalate, polyphenyleneether, polyamide, polycarbonate, polyacetal, polybutylene terephthalate, polyphenylene sulfide, polyether ether ketone, polyetherimide, polyethersulfone, liquid crystal polymer, fluorocarbon polymer, polyvinyl acetate, styrene-butadiene rubber and copolymer thereof.

In a preferred embodiment of the above mentioned unsaturated polyester resin composition for an LED reflector according to the present invention, as a thermoplastic resin, it may be used by itself or by the combination of two or more selected from a group consisting of polymethyl methacrylate, polystyrene, acrylonitrile butadiene styrene, polyethylene, polypropylene, polyvinyl acetate, styrene-butadiene rubber and copolymer thereof.

The unsaturated polyester resin according to the present invention can be obtained by mixing the unsaturated polyester resin, a copolymerizable monomer and/or a copolymerizable prepolymer, and the thermoplastic resin. Although in general, it is possible to mix the copolymerizable monomer and/or the copolymerizable prepolymer, and the thermoplastic resin with the resin together with other materials during preparation of the resin composition, it is possible to mix it with the resin before the preparation of the resin composition. For the thermoplastic resin, it is possible to use a method wherein a powder or a granular material is used as it is, or a method wherein a liquid state is used wherein the copolymerizable monomer and/or the copolymerizable prepolymer are solved in advance.

Moreover, in the unsaturated polyester resin composition for an LED reflector according to the present invention, an amount etc., of the thermoplastic resin is not particularly limited to, but in a preferred embodiment, from a viewpoint of a low shrinkage and an image clarity, in the unsaturated polyester resin, a total amount of the unsaturated polyester and a copolymerizable monomer and/or a copolymerizable prepolymer is from 99 to 55 part by weight, the thermoplastic resin is from 1 to 50 part by weight. From a viewpoint of a reflectance after a test for heat resistance, more preferably, in the unsaturated polyester resin, a total amount of the unsaturated polyester and a copolymerizable monomer and/or a copolymerizable prepolymer is from 97 to 60 part by weight, the thermoplastic resin is from 3 to 40 part by weight.

Furthermore, in a preferred embodiment of the unsaturated polyester resin composition for an LED reflector according to the present invention, from a viewpoint of a moldability, a reflectance after a test for heat resistance, the unsaturated polyester resin is from 10 to 35 percent by weight for total amount of composition, a total amount of an inorganic filler and a white pigment is from 50 to 80 percent by weight for total amount of composition, from a viewpoint of an initial reflectance, a reflectance after a test for heat resistance, a ratio of the white pigment in total amount of the inorganic filler and the white pigment is 10 to 50 percent by weight.

Moreover, in a preferred embodiment of the unsaturated polyester resin composition for an LED reflector according to the present invention, it is characterized in that the unsaturated polyester resin comprises at least crystalline unsaturated polyester resin. It is in a range that a total amount of the unsaturated polyester containing a crystalline unsaturated polyester and a copolymerizable monomer and/or a copolymerizable prepolymer is from 99 to 55 part by weight, the thermoplastic resin is from 1 to 50 part by weight, preferably, it is in a range that a total amount of the unsaturated polyester containing a crystalline unsaturated polyester and a copolymerizable monomer and/or a copolymerizable prepolymer is from 97 to 60 part by weight, the thermoplastic resin is from 3 to 40 part by weight, more preferably, it is in a range that a total amount of the unsaturated polyester containing a crystalline unsaturated polyester and a copolymerizable monomer and/or a copolymerizable prepolymer is from 97 to 70 part by weight, the thermoplastic resin is from 3 to 30 part by weight. There is a possibility that in the case that a ratio of the thermoplastic resin is too small, a shrinkage becomes large and an image clarity becomes low, in the case that it is too many, there is a possibility that a reflectance after a test for heat resistance becomes low.

Concerning the crystalline and amorphous unsaturated polyester resin which does not contain the thermoplastic resin, it is explained in the paragraph [0094] to [0101].

Moreover, in a preferred embodiment of the unsaturated polyester resin composition for an LED reflector according to the present invention, it is characterized in that the crystalline unsaturated polyester resin is a solid state in a temperature range of 50°C or less from a viewpoint of a dimensional stability in storage, a handleability and a workability. That is, it is a solid state in a temperature range from a room temperature or more to 50°C or less, and a grinding process or an extrusion and pelletizing process can be carried out.

Moreover, in a preferred embodiment of above mentioned unsaturated polyester resin composition for an LED reflector according to the present invention, it is characterized in that a copolymerizable monomer of a liquid state at a room temperature is 50 percent by weight or more for total amount of a copolymerizable monomer and/or a copolymerizable prepolymer. The use of the crystalline unsaturated polyester as an unsaturated polyester resin makes it possible to produce an advantage that a solid state of an unsaturated polyester resin composition in a temperature range of 50 °C or less is obtained even if a 50 percent by weight or more of a copolymerizable monomer of a liquid state at a room temperature for total amount of a copolymerizable monomer and/or a copolymerizable prepolymer is used.

Moreover, in a preferred embodiment of above mentioned unsaturated polyester resin composition for an LED reflector according to the present invention, from a viewpoint of a flowability and a heat resistance, the crystalline unsaturated polyester resin is from 10 to 35 percent by weight for a total amount of the composition, a total amount of the inorganic filler and the white pigment is from 50 to 80 percent by weight for total amount of composition. Moreover, from a viewpoint of a reflectance, in a preferred embodiment, a ratio of the white pigment in the total amount of the inorganic filler and the white pigment is from 10 to 50 percent by weight. Further, from a viewpoint of a cost of the white pigment and a catalytic effect, a ratio of the white pigment in the total amount of the inorganic filler and the white pigment is more preferably from 10 to 29 percent by weight.

A formulation ratio of the crystalline unsaturated polyester resin is preferably from 10 to 35 percent by weight for a total amount of the composition. Because there is a possibility that a flowability reduces and a moldability becomes worse in the case that it is less than 10 percent by weight, and there is a possibility that a heat resistance reduces in that case that it is more than 35 percent by weight.

The crystalline unsaturated polyester capable of using in the present invention is no compatibility with acetone, styrene monomer etc., at a room temperature and the crystalline unsaturated polyester resin comprising a mixture formulated with a crystalline unsaturated polyester and a copolymerizable monomer and/or a copolymerizable prepolymer is also a solid state at a room temperature. It's property is that the crystalline unsaturated polyester does not solve if acetone, styrene monomer etc., is added to the crystalline unsaturated polyester at a room temperature. On the other hand, the amorphous unsaturated polyester is compatibility with acetone, styrene monomer etc., and it's property is that it becomes liquid state if acetone, styrene monomer etc., is added to the amorphous unsaturated polyester, a mixture of the amorphous unsaturated polyester and a copolymerizable monomer and/or a copolymerizable polymer is a liquid state of resin.

An unsaturated polyester is obtained by reacting with an unsaturated polybasic acid, a saturated polybasic acid and glycols according to a known dehydration condensation reaction, and thereby having an acid value of 5 to 40 mg-KOH/g generally.

It is possible to obtain an unsaturated polyester having a crystalline by selecting an acid component or a combination of an unsaturated polybasic acid, a saturated polybasic acid, and selecting or combining glycols, and selecting a ratio of formulation thereof accordingly in a manufacture of an unsaturated polyester.

As an unsaturated polybasic acid, mention may be made of maleic acid, maleic anhydride, fumaric acid, citraconic acid, mesaconic acid, itaconic acid, tetrahydrophthalic acid, tetrahydrophthalic anhydride, methyltetrahydrophthalic anhydride, glutaconic acid etc.

As a saturated polybasic acid, mention may be made of phthalic acid, phthalic anhydride, isophthalic acid, terephthalic acid, succinic acid, adipic acid, sebacic acid, azelaic acid, tetrahydrophthalic anhydride, methyltetrahydrophthalic anhydride, endo methylene - tetra - hydro phthalic anhydride, HET acid, tetrabromophthalic anhydride etc.

As glycols, mention may be made of ethylene glycol, 1,3 - propanediol, 1,4 - butanediol, 1,5 - pentanediol, 1,6 - hexanediol, propylene glycol, diethylene glycol, triethylene glycol, dipropylene glycol, neopentyl glycol, 1,3 - butanediol, hydrogenated bisphenol-A, bisphenol-A propylene oxide adduct compound, cyclohexanedimethanol, dibromo neopentyl glycoletc etc.

In the present invention, among a crystalline unsaturated polyester, a crystalline unsaturated polyester is preferable wherein fumaric acid is used as an unsaturated polybasic acid, isophthalic acid or terephthalic acid is used as a saturated polybasic acid, ethylene glycol, 1,3-propanediol, 1,4 - butanediol, 1,5 - pentanediol, 1,6 - hexanediol, cyclohexanedimethanol are used as a primary component of glycol.

As a copolymerizable monomer mixed with the unsaturated polyester according to the present invention, for example, mention may be made of vinyl aromatic compound such as styrene monomer, α-methylstyrene, vinyl toluene, α- chlorostyrene which have a vinyl group; vinyl ester such as vinyl acetate, vinyl propionate, vinyl lactate, vinyl butyrate, VeoVa monomer (Shell Chemicals Japan Ltd.); (meta) acrylic ester such as methyl acrylate, ethyl acrylate, n-butyl acrylate, methyl methacrylate, ethyl methacrylate, n-butyl methacrylate etc.

Moreover, it is possible to use a copolymerizable monomer with two functional or more such as triacyl cyanurate, diethylene glycol dimethacrylate, diallyl tetrabromo phthalate, phenoxyethyl acrylate, 2- hydroxyethyl acrylate, 1,6- hexanediol diacrylate etc. Further, it is possible to use a copolymerizable monomer with two functional or more which is a solid state at a room temperature, such as polyethyleneglycol di(meta)acrylate, ethoxylated isocyanuric acid triacrylate, pentaerythritol tetraacrylate etc. These copolymerizable monomer may be used by itself or by the combination of two or more thereof.

In the unsaturated polyester resin composition for an LED reflector according to the present invention, it is possible to use a liquid state of a copolymerizable monomer and a solid state of a copolymerizable monomer at a room temperature as a copolymerizable monomer. In the unsaturated polyester resin composition for an LED reflector containing a crystalline unsaturated polyester according to the present invention, a copolymerizable monomer of a liquid state at a room temperature for total amount of a copolymerizable monomer and/or a copolymerizable prepolymer is preferably 50 percent by weight or more. The use of 50 percent by weight or more of a copolymerizable monomer of a liquid state at a room temperature for total amount of a copolymerizable monomer and/or a copolymerizable prepolymer makes it possible to fill a filler contained in a resin composition highly and thereby improving a heat resistance. A ratio of a copolymerizable monomer of a liquid state at a room temperature for total amount of a copolymerizable monomer and/or a copolymerizable prepolymer is preferably 70 percent by weight or more, more preferably 90 percent by weight or more. It is possible to use, in particular, styrene monomer, methyl methacrylate, diethylene glycol dimetaacrylate preferably. Since an amorphous unsaturated polyester resin composition comprising an amorphous unsaturated polyester and a copolymerizable monomer of a liquid state at a room temperature has a low drying property by set to the touch, there is a possibility that a workability and a dimensional stability in storage reduce. Moreover, it is possible to use a copolymerizable prepolymer in a range that does not impair a flowability during molding. It is possible to use a diallyl phthalate prepolymer etc., as a copolymerizable prepolymer.

It is possible to formulate an inorganic filler in the unsaturated polyester resin composition for an LED reflector according to the present invention. Although as an inorganic filler, mention may be made of calcium carbonate, magnesium carbonate, barium carbonate, calcium hydroxide, aluminum hydroxide, magnesium oxide, mica, silica, aluminum oxide, but from a viewpoint of reflectance ratio, calcium carbonate, aluminum hydroxide among them is preferable. These may be used by itself or a combination of two or more.

The average particle diameter of the inorganic filler is used within a range from 0.1 to 50 µm, preferably from 0.1 to 20 µm. The average particle diameter is measured by a median size or a measurement of a geometric average value according to a laser diffraction /scattering type of a device of measuring a particle size distribution. However, there are possibility that the average particle diameter is different according to the used method of calculating. The use of the inorganic filler having an average particle diameter makes it possible to obtain the unsaturated polyester resin for an LED reflector having a superior flowability for molding, a superior heat discoloration resistance and reflectance.

Furthermore, in a preferred embodiment of above mentioned unsaturated polyester resin composition for an LED reflector according to the present invention, it is characterized in that the white pigment is at least one or more selected from a group of titanium oxide, barium titanate, barium sulfate, zinc oxide, zinc sulfide. In the present invention, among these white pigment, from a viewpoint of a reflectance, in particular, it is possible to use titanium oxide preferably. As titanium oxide, for example, mention may be made of an anatase type of titanium oxide, a rutile type of titanium oxide, a brookite type of titanium oxide. Among them, a rutile type of titanium oxide having a superior heat stability can be preferably used. It is also possible to use any titanium oxide surface treated by a treating agent, as long as the objects of the present invention are not impaired.

Moreover, in a preferred embodiment of above mentioned unsaturated polyester resin composition for an LED reflector according to the present invention, it is characterized in that the average particle diameter of the white pigment is 2.0 µm or less. Moreover, the average particle diameter of the white pigment is preferably 2.0 µm or less, more preferably from 0.01 to 1.0 µm, further more preferably from 0.1 to 0.5 µm from a viewpoint of a reflectance. The average particle diameter is calculated by a measurement of an initial particle using an electron microscope. Moreover, there is possibility that a superior moldability can not be obtained and thereby it being impossible to obtain a high reflectance in the case that an average particle diameter of the white pigment is large.

In the unsaturated polyester resin composition for an LED reflector, a reinforcing material can be formulated. The use of the reinforcing material makes it possible to obtain an unsaturated polyester resin composition for an LED reflector having a superior strength characteristic, dimensional stability.

Although as a reinforcing material, in general, glass fiber can be used which is used as a reinforcing material of an unsaturated polyester resin composition used for a fiber-reinforced plastic (FRP) such as a bulk molding compound (BMC), a sheet molding compounds (SMC), it is not limited to glass fibers, but those other than the glass fibers can be also used. Although as a reinforcing material used for other than the glass fibers, mention may be made of carbon fibers, an inorganic fibers such as whisker, an organic fibers such as aramid fibers or polypropylene fibers, aramid fibers or polypropylene fibers are preferable.

As glass fibers, mention may be made of glass fibers such as E glass (non - alkali glass fibers for electricity) wherein the raw material is silicate glass, borosilicate glass, C glass (alkali glass fibers for chemistry), A glass (acid-resistant glass), S glass (high-strength glass), those of continuous fibers (roving), discontinuous fibers (chopped strand) can be used. Further, those of the surface-treated these glass fibers can be also used.

Among them, from a viewpoint of a size and shape of molded articles, the use of the discontinuous fibers (chopped strands) are preferable. Moreover, in the case of a woven material or a nonwoven fabric, it is not suitable for the present invention because it is difficult to uniformly mix it with other resin composition, that is, the unsaturated polyester resin, the white pigment and the inorganic filler etc. Further, there is possibility that it is difficult to fill the composition to the end of minute and complicated molded articles since long glass fibers make flowability of a resin composition poor. In the case that an L/D (a ratio of a length of fiber for a diameter of fiber) is small, there is possibility that a stiffening effect as a reinforcing material is not attained. A preferable length of fiber of the reinforcing material used in the present invention is in a range from 1.5 to 13 mm, and a diameter of fiber is in a range from 6 to 15 µm.

Moreover, in a preferred embodiment of the unsaturated polyester resin composition for an LED reflector according to the present invention, the unsaturated polyester resin composition for an LED reflector is characterized by containing 3 to 20 percent by weight of one or more of the reinforcing material selected from a group consisting of glass fibers, aramid fibers, polypropylene fibers for the composition.

In the crystalline unsaturated polyester resin composition for an LED reflector, it is possible to use a thermolysis type of an organic peroxide as a polymerization initiator or a polymerization inhibitor which is generally used to the unsaturated polyester resin composition.

As an organic peroxide, mention may be made of t - butylperoxy - 2-ethylhexyl monocarbonate, 1,1-di(t-hexylperoxy) cyclohexane, 1,1-di(t-butylperoxy)- 3,3,5 - trimethyl cyclohexane, t - butyl peroxyoctoate, benzoyl peroxide, methyl ethyl ketone peroxide, acetylacetone peroxide, t - butylperoxy benzoate, dicumyl peroxide etc. These may be used by itself or by the combination of two or more thereof.

Among them, from a viewpoint of molding conditions, stability of storage, the use of organic peroxide wherein the 10 hours half-life temperature is 100 °C or more, is preferable, and specifically dicumyl peroxide can be used preferably.

As a polymerization inhibitor, mention may be made of quinones such as hydroquinone, monomethyl ether hydroquinone, toluhydroquinone, di - t - 4 - methylphenol, monomethyl ether hydroquinone, phenothiazine, t- buthyl catechol, parabenzoquinone, pyrogallol, a phenolic compound such as 2,6 - di - t - butyl - cresol, 2,2 - methylene - bis - (4 - methyl - 6 - t - butyl phenol), 1,1,3 - tris - (2-methyl - 4 - hydroxyl - 5 - t - butyl phenyl) butane etc. These may be used by itself or by the combination of two or more thereof.

Moreover, it is possible to formulate other inorganic filler appropriately to the unsaturated polyester resin composition for an LED reflector according to the present invention in a range keeping features such as a flowability of a resin composition or a reflectance when it is molded to an LED reflector.

As these type of other inorganic filler, mention may be made of an empty particle such as an oxide or hydrate thereof, an inorganic bubble particle, a silica balloon etc.

It is possible to use a release agent in the unsaturated polyester resin composition for an LED reflector according to the present invention. As a release agent, mention may be made of waxes such as fatty acid type, fatty acid metal salt type, mineral type etc., which is generally used for a thermosetting resin, in particular, it is possible to preferably use those of fatty acid type, fatty acid metal salt type of waxes which is superior for a heat discoloration resistance.

As these release agent, specifically mention may be made of stearic acid, zinc stearate, aluminum stearate, calcium stearate. These release agent may be used by itself or by the combination of two or more thereof.

These release agent can be formulated with 3 to 15 parts by weight for 100 parts by weight of the unsaturated polyester resin. This range of the formulated amount of the release agent makes it possible to keep a good property of mold release. In the case that it is too small, there is possibility that a property of mold release between a die and a molded article becomes low and thereby reducing a productivity extremely, and in the case that it is too much, there is possibility that a sealant cannot be attached firmly. Since there is no need to coat the release agent to the die by means of the formulation of the release agent to the composition in advance, it is possible to apply it to a molding method such as an injection molding wherein a molding cycle is short.

In the present invention, other than these components, according to need, it is possible to accordingly formulate a polymerization initiator and a polymerization inhibitor in order to control a curing condition of the unsaturated polyester resin composition, a colorant, a thickener, a light stabilizer, a processing stabilizer, an ultraviolet absorber, a nucleating agent, a fluorescent brightening agent, a fire retardant, a photopolymerization initiator, an antibacterial agent, an antistatic agent, a foaming agent, a surfactant, a surface modifier, a coupling agent, the other organic additive agent and inorganic additive agent.

The unsaturated polyester resin composition for an LED reflector according to the present invention can be manufactured by formulating each components to mix it adequately and uniformly by using a mixer, a blender and after that, to control and granulate by using a mixer, an extruder capable of applying heat and pressure. Since in the case that a glass woven fabric is used as a reinforcement, it is possible to mix and granulate adequately by using a mixer, an extruder, and in the case that nonwoven glass fabric is used, it is impossible to keep a shape of nonwoven fabric because a sheet type of nonwoven fabric is destroyed during mixture, it cannot find out a superiority of the use of woven fabric and nonwoven fabric.

Furthermore, a granular material according to the present invention is characterized in that the granular material comprises the unsaturated polyester resin composition for an LED reflector according to the present invention. The granular material comprising the crystalline unsaturated polyester resin composition for an LED reflector according to the present invention may be a fine particle obtained by grinding the composition or a pellet form.

Furthermore, an LED reflector according to the present invention is characterized by molding the granular material comprising the unsaturated polyester resin composition for an LED reflector according to the present invention. It is possible to mold the LED reflector by a various sort of a method of molding a thermosetting resin according to a common procedure.

Furthermore, an unsaturated polyester resin composition for an LED reflector according to the present invention is a dry type and a good heat stability during melting, it is possible to use preferably a melt-heat molding process such as an injection molding process, an injection compression molding process, transfer molding process etc. since in a laminated sheet using a glass woven fabric or a nonwoven glass fabric as a reinforcement, it is needed to impregnate the resin composition into a woven fabric or a nonwoven fabric in advance, the resin composition must be a liquid state, and therefore, it is different characteristic comparing with the unsaturated polyester resin composition according to the present invention. The molding process is limited to a pressure molding process using a press.

Among them, the injection molding process using an injection molding machine is preferably, the use of injection molding process makes it possible to further shorten a time for molding cycle and to manufacture an LED reflector having a complicated shape for mounting a light emitting element, different from a tabular laminated sheet.

Next, the radical polymerizable resin composition for an LED reflector according to the present invention, and a granular material comprising the composition, a method of molding by using the granular material and an LED reflector, will be explained as follows.

A radical polymerizable resin composition for LED reflector according to the present invention is characterized by comprising at least an radical polymerizable resin, an inorganic filler, a white pigment, wherein a degree of viscosity of the radical polymerizable resin composition is in a range from 0.1 to 100 kPa-s. A radical polymerizable resin composition according to the present invention can be mainly used for the injection molding. In a general injection molding, a resin composition is filled into a hopper capable of pooling a certain amount of the resin composition, the resin composition is supplied by it's own weight from a hopper into a screw. Therefore, it is needed that the resin composition is a solid state at a room temperature. Although in general, a high degree of freedom for a shape of a molded article and a high productivity is a characteristic of an injection molding, in the case of a thermosetting resin containing a radical polymerizable resin, it is also a characteristic that it is possible to mold by a lower pressure of injection since a melt viscosity of the resin composition is low. On the other hand, there is a problem of the thermosetting resin on the injection molding process that it is need to make a curing speed increase, that is, to shorten a cycle time. Since a radical polymerizable resin according to the present invention has a suitable viscosity for the injection molding, and further an appropriate curing speed, it can be preferably used for a resin composition for the injection molding.

In the present invention, as a radical polymeraizable resin, mention may be made of unsaturated polyester, a modified (meta) acrylate added (meta) acrylic acid such as epoxy (meta) acrylate, urethane (meta) acrylate, polyester (meta) acrylate, polyether (meta) acrylate etc.

An unsaturated polyester can be obtained by reacting with an unsaturated polybasic acid, a saturated polybasic acid and glycols according to a known dehydration condensation reaction, and thereby being able to have an acid value of 5 to 40 mg-KOH/g generally.

As an unsaturated polybasic acid, mention may be made of maleic acid, maleic anhydride, fumaric acid, citraconic acid, mesaconic acid, itaconic acid, tetrahydrophthalic acid, tetrahydrophthalic anhydride, methyltetrahydrophthalic anhydride, glutaconic acid etc.

As a saturated polybasic acid, mention may be made of phthalic acid, phthalic anhydride, isophthalic acid, terephthalic acid, succinic acid, adipic acid, sebacic acid, azelaic acid, tetrahydrophthalic anhydride, methyltetrahydrophthalic anhydride, endo methylene - tetra - hydro phthalic anhydride, HET acid, tetrabromophthalic anhydride etc.

As glycols, mention may be made of ethylene glycol, 1,3 - propanediol, 1,4 - butanediol, 1,5 - pentanediol, 1,6 - hexanediol, propylene glycol, diethylene glycol, triethylene glycol, dipropylene glycol, neopentyl glycol, 1,3 - butanediol, bisphenol-A hydride, bisphenol-A propylene oxide compound, cyclohexanedimethanol, dibromo neopentyl glycol etc.

The unsaturated polyester resin according to the present invention can be obtained by mixing the unsaturated polyester resin, a copolymerizable monomer and/or a copolymerizable prepolymer. Although in general, it is possible to mix the copolymerizable monomer and/or the copolymerizable prepolymer with the resin together with other materials during preparation of the resin composition, it is possible to mix it with the resin before the preparation of the resin composition.

As a copolymerizable monomer mixed with the unsaturated polyester according to the present invention, for example, mention may be made of vinyl aromatic compound such as styrene monomer, α-methylstyrene, vinyl toluene, α- chlorostyrene which have a vinyl group; vinyl ester such as vinyl acetate, vinyl propionate, vinyl lactate, vinyl butyrate, VeoVa monomer (Shell Chemicals Japan Ltd.); (meta) acrylic ester such as methyl acrylate, ethyl acrylate, n-butyl acrylate, methyl methacrylate, ethyl methacrylate, n-butyl methacrylate etc.

Moreover, it is possible to use a copolymerizable monomer with two functional or more such as triacyl cyanurate, diethylene glycol dimethacrylate, diallyl tetrabromo phthalate, phenoxyethyl acrylate, 2- hydroxyethyl acrylate, 1,6- hexanediol diacrylate etc. Further, it is possible to use a copolymerizable monomer with two functional or more which is a solid state at a room temperature, such as polyethyleneglycol di(meta)acrylate, ethoxylated isocyanuric acid triacrylate, pentaerythritol tetraacrylate etc. These copolymerizable monomer may be used by itself or by the combination of two or more thereof.

Epoxy (meta) acrylate in the present invention is an epoxy (meta) acrylate having an epoxy group at the end of molecule obtained by the addition reaction between an epoxy resin having two or more of glycidyl ether group in one molecule and acrylic acid or methacrylic acid. An epoxy acrylate resin wherein epoxy acrylate is melted to a copolymerizable monomer and/or a copolymerizable prepolymer. As the above epoxy resin having two or more of glycidyl ether group in one molecule, for example, mention may be made of epoxy resin such as a bisphenol type of epoxy resin derived from bisphenol A, bisphenol F, bisphenol S etc., or these derivative, a bixylenol type of epoxy resin derived from bixylenol or the derivative thereof, a biphenol type of epoxy resin derived from biphenol or the derivative thereof, or naphthalene type of epoxy resin derived from naphthalene or the derivative thereof, and further novolak type of epoxy resin. There can be used by itself or the combination of two or more. As a copolymerizable monomer and/or a copolymerizable prepolymer, the same a copolymerizable monomer and/or a copolymerizable prepolymer as those used for the above unsaturated polyester resin can be used.

Moreover, urethane (meta) acrylate in the present invention is an urethane acrylate having a double bond of acrylate or methacrylate at the end of molecule obtained by reacting polyalcohol and / or polyester polyol and / or polyether polyol with diisocyanate to add isocyanate group at the end of molecule and thereby reacting this with acrylate or methacrylate having an alcoholic hydroxyl group, or by reacting acrylate or methacrylate having an alcoholic hydroxyl group with isocyanate firstly maintaining isocyanate group, and thereby reacting with polyalcohol and / or polyester polyol and / or polyether polyol. It may be urethane acrylate resin obtained by dissolving urethane methacrylate to a copolymerizable monomer and/or a copolymerizable polymer such as styrene, diethylene glycol dimethacrylate. These may be used by itself or by the mixture of two or more thereof.

Moreover, polyester (meta) acrylate in the present invention is a polyester acrylate or polyester methacrylate having a double bond of acrylate or methacrylate at the end of molecular obtained by esterification reaction between polyester polyol and acrylic acid or methacrylic acid, or by reaction between an acid terminated polyester and acrylate or methacrylate having a glycidyl group. It may be a polyester acrylate or polyester methacrylate resin obtained by dissolving polyester acrylate or polyester methacrylate to a copolymerizable monomer and/or a copolymerizable prepolymer such as styrene, diethylene glycol dimethacrylate. These may be used by itself or by the mixture of two or more thereof.

Moreover, polyether (meta) acrylate in the present invention is a polyether acrylate or polyether methacrylate having a double bond of acrylate or methacrylate at the end of molecular obtained by etherification reaction between polyether polyol and acrylic acid or methacrylic acid, or by reaction between an acid terminated polyether and acrylate or methacrylate having a glycidyl group. It may be a polyether acrylate or polyether methacrylate resin obtained by dissolving polyether acrylate or polyether methacrylate to a copolymerizable monomer and/or a copolymerizable polymer such as styrene, diethylene glycol dimethacrylate. These may be used by itself or by the mixture of two or more thereof.

In a radical polymerizable resin composition for LED reflector according to the present invention, from a viewpoint of a moldability, a reflectance after a test for heat resistance, the radical polymerizable resin is from 10 to 35 percent by weight for total amount of composition, a total amount of the inorganic filler and the white pigment is from 50 to 80 percent by weight for total amount of composition, and from a viewpoint of an initial reflectance, a reflectance after a test for heat resistance, a ratio of the white pigment in a total amount of the inorganic filler and the white pigment is from 10 to 50 percent by weight.

As an inorganic filler used in the radical polymerizable resin for an LED reflector according to the present invention, mention may be made of calcium carbonate, magnesium carbonate, barium carbonate, calcium hydroxide, aluminum hydroxide, magnesium oxide, mica, silica, aluminum oxide, but from a viewpoint of reflectance, calcium carbonate, aluminum hydroxide among them is preferable. These may be used by itself or a combination of two or more.

The average particle diameter of the inorganic filler can be used within a range from 0.1 to 50 µm, preferably from 0.1 to 20 µm. The average particle diameter is measured by a median size or a measurement of a geometric average value according to a laser diffraction /scattering type of a device of measuring a particle size distribution. However, there are possibility that the average particle diameter is different according to the used method of calculating.

Furthermore, as the white pigment used in the radical polymerizable resin for an LED reflector according to the present invention, mention may be made of titanium oxide, barium titanate, barium sulfate, zinc oxide, zinc sulfide. In the present invention, among these white pigment, from a viewpoint of a reflectance, in particular, it is possible to use titanium oxide preferably. As titanium oxide, for example, mention may be made of an anatase type of titanium oxide, a rutile type of titanium oxide, a brookite type of titanium oxide. Among them, a rutile type of titanium oxide having a superior heat stability can be preferably used. It is also possible to use any titanium oxide surface treated by a treating agent, as long as the objects of the present invention are not impaired.

Moreover, the average particle diameter of the white pigment used in the radical polymerizable resin composition for an LED reflector according to the present invention, from a viewpoint of a reflectance ratio, can be preferably 2.0 µm or less, more preferably from 0.01 to 1.0 µm, further more preferably from 0.1 to 0.5 µm. The average particle diameter is calculated by a measurement of an initial particle using an electron microscope. Moreover, there is possibility that a superior formability can not be obtained and thereby it being impossible to obtain a high reflectance in the case that an average particle diameter of the white pigment is large.

The radical polymerizable resin composition for an LED reflector according to the present invention is characterized in that a degree of viscosity of the radical polymerizable resin composition is in a range from 0.1 to 100kPa-s. There is possibility that in the case that the degree of viscosity is less than 0.1 kPa-s, since it tends to fill in excessive quantities because of a good flowability in a die, and thereby generating defective product such as flash. There is possibility that in the case that the degree of viscosity is more than 100 kPa-s, a flowability in a die becomes worse and thereby generating defective product by a shortage of filling.

In general, in the injection molding of the thermosetting resin containing a radical polymerizable resin, it is molded by plasticizing the resin composition by means of a screw in a heated cylinder, and injecting a melting state of the resin composition into a die.

In the injection molding of the radical polymerizable resin composition such as the unsaturated polyester resin etc., after the resin composition is filled into the end of the die, a radical polymerization reaction (gelation) occurs, a molded article has a sufficient strength by curing and after that it is needed to be took it out from the die. Therefore, the control between a melting viscosity of the resin composition and a speed of polymerization reaction is important.

Although a resin composition having a low melting viscosity produces a superior flowability in a die, but there is possibility that it is easy to fill in excessive quantities and thereby generating defective product such as flash. On the other hand, a resin composition having a high melting viscosity renders a worse flowability in a die, a polymerization reaction occurs before the resin composition arrives at the end of a molded article, and thereby there being possibility that a defective product is generated by a shortage of filling.

In further preferred embodiment of the radical polymerizable resin composition for an LED reflector according to the present invention, it is characterized in that a degree of viscosity of the radical polymerizable resin composition is in a range from 0.1 to 100kPa-s at a temperature range from 70 to 120 °C. In the case that the temperature is less than 70 °C, it is difficult to mold by injection molding since the resin composition is not melted. Even if it is possible to mold by injection molding, there is possibility that it is impossible to fill the resin composition into the end of a die because of a high viscosity of the resin composition. On the other hand, in the case that it is more than 120 °C, a curing reaction occurs in a cylinder during molding, there is possibility that it is difficult to carry out a continuous molding. Even if it is possible to mold by injection molding, there is possibility that the injected resin composition into a die flows back, and it is impossible to fill the resin composition into the end of a die. In order to fill it into the end of a die, if a content of injection increases, there is possibility that a flash becomes large during molding because the viscosity of the resin composition is low. From the above reason, a degree of viscosity of the radical polymerizable resin composition for an LED reflector is preferably in a range from 0.1 to 100kPa-s in a temperature range from 70 to 120°C.

In a preferred embodiment of above mentioned radical polymerizable resin composition for an LED reflector according to the present invention, it is characterized in that the radical polymerizable resin composition for an LED reflector contains an unsaturated polyester resin.

In a preferred embodiment of the radical polymerizable resin composition for an LED reflector according to the present invention, it is characterized in that the radical polymerizable resin composition for an LED reflector contains a crystalline unsaturated polyester resin.

The difference between an amorphous unsaturated polyester resin and a crystalline unsaturated polyester resin will be explained as follows. That is, a crystalline unsaturated polyester resin comprising a crystalline unsaturated polyester and a liquid state of a copolymerizable monomer at a room temperature is a solid state at a room temperature and is a liquid state and a low viscosity at a melting point or more of a crystalline unsaturated polyester resin. On the other hand, an amorphous unsaturated polyester resin comprising an amorphous unsaturated polyester and a liquid state of a copolymerizable monomer at a room temperature is a liquid state at a room temperature.

As an unsaturated polyester resin composition capable of being molded by an injection molding and using a general copolymerizable monomer such as a styrene monomer, a wet type of BMC at a room temperature is known. The BMC uses an unsaturated polyester resin, and there are some problems such as (a) an ancillary facility such as a plunger for pressing into a molding machine is needed, (b) a handleability is poor since it is blocky, and a workability is poor since it is formless, (c) a storage stability is poor since it is wet type.

A solid type of an amorphous unsaturated polyester resin composition at room temperature is solved the above problems (a) to (c) by using the amorphous unsaturated polyester with a solid state of a copolymerizable monomer at room temperature, a copolymerizable prepolymer and a liquid state of a copolymerizable monomer in a usable range. On the other hand, it is possible to combine a crystalline unsaturated polyester resin and a liquid state or a solid state of a copolymerizable monomer and a copolymerizable prepolymer at a room temperature in a given range.

In the radical polymerizable resin composition for an LED reflector according to the present invention, from a viewpoint that it is possible to use a small diameter of the white pigment and the inorganic filler capable of increasing a viscosity of the resin composition, a crystalline unsaturated polyester resin capable of combining a liquid state or a solid state of a copolymerizable monomer and a copolymerizable prepolymer at a room temperature in any range.

In the radical polymerizable resin composition for an LED reflector according to the present invention, from a viewpoint that a granulatability or a storage stability is superior, a solid state of a crystalline unsaturated polyester resin at a room temperature can be preferably used as an unsaturated polyester resin.

In the present invention, a crystalline unsaturated polyester is preferably used wherein fumaric acid is used as an unsaturated polybasic acid, isophthalic acid or terephthalic acid is used as a saturated polybasic acid, from a viewpoint of a crystalline, ethylene glycol, 1,3 - propanediol, 1,4 - butanediol, 1,5 - pentanediol, 1,6-hexanediol, cyclohexanedimethanol are used as a primary component of glycol.

A gel time of the unsaturated polyester resin composition was measured by a heat - pressure molding using a die with a differential transformer type position sensor. After the resin composition is set into the die, although a differential transformer stops (inflexion point 1) at a time that the die is clamped (the die with a differential transformer type position sensor) is raised up and it becomes a constant thickness, but an S-curve of displacement - time was obtained wherein since a hardening shrinkage begins according to the progress of hardening, a position of the differential transformer starts moving upward again (inflexion point 2). A time between an inflexion point 1 and an inflexion point 2 is defined as a gel time.

Moreover, in a preferred embodiment of the radical polymerizable resin composition for an LED reflector according to the present invention, it is characterized in that a gel time of the radical polymerizable resin composition in a temperature range from 140 to 180°C is in a range of 5 to 120 sec. There is a possibility that in the case that a gel time of the radical polymerizable resin composition in a temperature range from 140 to 180°C is less than 5 sec, because a gelation of the resin composition occurs before it is filled into a cavity of the die, it is impossible to transcribe a surface of the die adequately and to obtain a molded article having a good surface smoothness. There is possibility that in the case that a gel time of the radical polymerizable resin composition in a temperature range from 140 to 180°C is more than 120 sec, since it is need to take a long time to cure, a productivity becomes worse and it's impossible to become widely used as a general reflector.

That is, it is important that a curing speed such as a gel time etc., is controlled in order to obtain a molded article having a superior quality. There is a possibility that in the case that a gel time is too short, since a gelation of the resin composition occurs before it is filled into a cavity of the die, it is impossible to transcribe a surface of the die adequately and to obtain a molded article having a good surface smoothness. On the other hand, there is a possibility that in the case that a gel time is too long, since it is need to take a long time to cure, a productivity becomes worse and it is impossible to become widely used as a general reflector.

A preferred embodiment of the present invention is a method of an injection molding wherein the radical polymerizable resin composition for an LED reflector is heated and cured at from 140 to 180 °C (a die temperature). There is a possibility that in the case that a die temperature is less than 140 °C, since it is need to take a long time to cure because of the slow speed of curing, a productivity becomes worse and it is impossible to become widely used as a general reflector. There is a possibility that in the case that a die temperature is more than 180 °C, it is impossible to obtain a product because a speed of curing is high and it tends to become a shortage of filling at the end portion.

In the radical polymerizable resin composition for an LED reflector, a reinforcing material can be formulated. The use of the reinforcing material makes it possible to obtain an unsaturated polyester resin composition for an LED reflector having a superior strength characteristic, dimensional stability.

Although as a reinforcing material, glass fibers can be used which is used as a reinforcing material of an unsaturated polyester resin composition used for a fiber-reinforced plastic (FRP) such as a bulk molding compound (BMC), a sheet molding compounds (SMC), in general it is not limited to glass fibers, but those other than the glass fibers can be also used. Although as a reinforcing material used for other than the glass fibers, mention may be made of carbon fibers, an inorganic fibers such as whiskers, an organic fibers such as aramid fibers or polypropylene fibers, aramid fibers or polypropylene fibers are preferable.

As glass fibers, mention may be made of glass fibers such as E glass (non - alkali glass fibers for electricity) wherein the raw material is silicate glass, borosilicate glass, C glass (alkali glass fibers for chemistry), A glass (acid-resistant glass), S glass (high-strength glass), those of continuous fibers (roving), discontinuous fibers (chopped strand) can be used. Further, those of the surface-treated these glass fibers can be also used.

Among them, from a viewpoint of a size and shape of molded articles, the use of the discontinuous fibers (chopped strands) is preferable. A preferable length of fibers of the reinforcing material used in the present invention is in a range from 1.5 to 13 mm, and a diameter of fibers is in a range from 6 to 15 µm.

In the radical polymerizable resin composition for an LED reflector, it is possible to use a thermolysis type of an organic peroxide as a polymerization initiator or a polymerization inhibitor which is generally used to the unsaturated polyester resin composition.

As an organic peroxide, mention may be made of t - butylperoxy - 2-ethylhexyl monocarbonate, 1,1-di(t-hexylperoxy) cyclohexane, 1,1-di(t-butylperoxy)- 3,3,5 - trimethyl cyclohexane, t - butyl peroxyoctoate, benzoyl peroxide, methyl ethyl ketone peroxide, acetylacetone peroxide, t - butylperoxy benzoate, dicumyl peroxide etc. These may be used by itself or by the combination of two or more thereof.

Among them, from a viewpoint of molding conditions, stability of storage, the use of organic peroxide wherein the 10 hours half-life temperature is 100 °C or more, is preferable, and specifically dicumyl peroxide can be used preferably.

As a polymerization inhibitor, mention may be made of quinones such as hydroquinone, monomethyl ether hydroquinone, toluhydroquinone, di - t - 4 - methylphenol, monomethyl ether hydroquinone, phenothiazine, t- buthyl catechol, parabenzoquinone, pyrogallol, a phenolic compound such as 2,6 - di - t - butyl - cresol, 2,2 - methylene - bis - (4 - methyl - 6 - t - butyl phenol, 1,1,3 - tris - (2-methyl - 4 - hydroxyl - 5 - t - butyl phenyl) butane. These may be used by itself or by the combination of two or more thereof.

Moreover, it is possible to formulate other inorganic filler appropriately to the radical polymerizable resin composition for an LED reflector according to the present invention in a range keeping features such as a flowability of a resin composition or a reflectance when it is molded to an LED reflector.

As these type of other inorganic filler, mention may be made of an empty particle such as an oxide or hydrate thereof, an inorganic bubble particle, a silica balloon etc.

It is possible to use a release agent in the radical polymerizable resin composition for an LED reflector according to the present invention. As a release agent, mention may be made of waxes such as fatty acid type, fatty acid metal salt type, mineral type etc., which is generally used for a thermpsettinng resin, in particular, it is possible to preferably use those of fatty acid type, fatty acid metal salt type of waxes which is superior for a heat discoloration.

As these release agent, specifically mention may be made of stearic acid, zinc stearate, aluminum stearate, calcium stearate. These mold release agent may be used by itself or by the combination of two or more thereof.

In the present invention, other than these components, according to need, it is possible to accordingly formulate a polymerization initiator and a polymerization inhibitor in order to control a curing condition of the radical polymerizable resin composition, a colorant, a thickener, a light stabilizer, a processing stabilizer, an ultraviolet absorber, a nucleating agent, a fluorescent brightening agent, a fire retardant, a photopolymerization initiator, an antibacterial agent, an antistatic agent, a foaming agent, a surfactant, a surface modifier, a coupling agent, the other organic additive agent and inorganic additive agent.

The radical polymerizable resin composition for an LED reflector according to the present invention can be manufactured by formulating each components to mix it adequately and uniformly by using a mixer, a blender and after that, to control and granulate by using a mixer, an extruder capable of applying heat and pressure.

Furthermore, a granular material according to the present invention is characterized in that the granular material comprises the radical polymerizable resin composition for an LED reflector according to the present invention. The granular material comprising the radical polymerizable resin composition for an LED reflector according to the present invention may be a fine particle obtained by grinding the composition or a pellet form.

Furthermore, an LED reflector according to the present invention is characterized by molding the granular material comprising the radical polymerizable resin composition for an LED reflector according to the present invention. It is possible to mold the LED reflector by a various sort of a method of molding a thermosetting resin according to a common procedure.

Furthermore, a radical polymerizable resin composition for an LED reflector according to the present invention is a dry type and a good heat stability during melting, it is possible to use preferably a melt-heat molding process such as an injection molding process, an injection compression molding process, transfer molding process etc. Among them, the injection molding process using an injection molding machine is preferably.

Next, the surface-mount-type light-emitting device with an LED reflector made by molding the unsaturated polyester resin composition, and lighting device and image display device each equipped with said light-emitting device, will be explained as follows.

A surface-mount-type light-emitting device according to the present invention is characterized in that it is made by molding an unsaturated polyester resin composition comprising at least an unsaturated polyester resin and an inorganic filler, and the unsaturated polyester resin comprises one or more selected from (A) an unsaturated polyester resin comprising an the crystalline unsaturated polyester, a copolymerizable monomer and/or a copolymerizable prepolymer, or (B) an unsaturated polyester resin comprising an unsaturated polyester, a copolymerizable monomer and/or a copolymerizable prepolymer, and a thermoplastic resin, and the unsaturated polyester resin composition contains a white pigment.

At first, the explanation regarding an unsaturated polyester resin (A) will be as follows. An unsaturated polyester resin (A) comprises the crystalline unsaturated polyester, a copolymerizable monomer and/or a copolymerizable prepolymer.

The unsaturated polyester resin (A) can be obtained by mixing the crystalline unsaturated polyester resin, a copolymerizable monomer and/or a copolymerizable prepolymer etc. Although in general, it is possible to mix the copolymerizable monomer and/or the copolymerizable prepolymer with the resin together with other materials during preparation of the resin composition, it is possible to mix it with the resin before the preparation of the resin composition.

Concerning the crystalline and amorphous unsaturated polyester resin used in the present invention, it is explained in the paragraph [0098] to [0102].

Furthermore, in a preferred embodiment of the crystalline unsaturated polyester resin composition for an LED reflector according to the present invention, it is characterized in that the crystalline unsaturated polyester resin is a solid state in a temperature range of 50°C or less, from a viewpoint of a dimensional stability in storage, a handleability and a workability. That is, it is possible to carry out a grinding process and an extrusion and pelletizing process since it is a solid state in a temperature range from a room temperature of more to 50°C or less.

Furthermore, the crystalline unsaturated polyester resin composition for an LED reflector according to the present invention can contain an amorphous unsaturated polyester in a range keeping features such as a dimensional stability in storage of the present invention.

Furthermore, in a preferred embodiment of the crystalline unsaturated polyester resin composition for an LED reflector according to the present invention, it is characterized in that the crystalline unsaturated polyester resin comprises 40 to 95 part by weight of a crystalline unsaturated polyester, 60 to 5 part by weight of a copolymerizable monomer and/or a copolymerizable prepolymer. It is preferable that the crystalline unsaturated polyester resin is formulated by a ratio of 50 to 95 part by weight of a crystalline unsaturated polyester, 50 to 5 part by weight of a copolymerizable monomer and/or a copolymerizable prepolymer. The reason why the above range is set is because in the case that an amount of a copolymerizable monomer and/or a copolymerizable prepolymer formulated to the crystalline unsaturated polyester is larger than the above range, there is possibility that it is impossible to carry out a grinding process or an extruding and pelletizing process and thereby reducing a handleability considerably, and in the case that an amount of a copolymerizable monomer and/or a copolymerizable prepolymer is smaller than the above range, there is possibility that a hardening property reduces and thereby it being difficult to obtain a reflector having a good appearance.

Next, the explanation regarding an unsaturated polyester resin (B) will be as follows. An unsaturated polyester resin (B) comprises the unsaturated polyester, a copolymerizable monomer and/or a copolymerizable prepolymer, and a thermoplastic resin.

As an unsaturated polyester resin used as a component of the unsaturated polyester resin (B), it is possible to use any unsaturated polyester resin without regard to crystal or amorphous. The thermoplastic resin is generally a resin which can be molded by heating and softening without occurring reaction to have a plasticity, but can become solidified if it is cooled. In the case of the repeat of cooling and heating, it is a resin which the plasticity is reversibly maintained. In the present invention, it is possible to use an unsaturated polyester resin composition containing such thermoplastic resin.

As the thermoplastic resin capable of being used as the unsaturated polyester resin (B), mention may be made of acrylonitrile butadiene stylene, polypropylene, polyethylene, polystyrene, polymethyl methacrylate, polyethylene terephthalate, polyethylene naphthalate, polyphenyleneether, polyamide, polycarbonate, polyacetal, polybutylene terephthalate, polyphenylene sulfide, polyether ether ketone, polyetherimide, polyethersulfone, liquid crystal polymer, fluorocarbon polymer, polyvinyl acetate, styrene-butadiene rubber and copolymer thereof.

In a preferred embodiment of the unsaturated polyester resin (B), as the thermoplastic resin, it may be used by itself or by the combination of two or more selected from a group consisting of polymethyl methacrylate, polystyrene, acrylonitrile butadiene styrene, polyethylene, polypropylene, polyvinyl acetate, styrene-butadiene rubber and copolymer thereof.

The unsaturated polyester resin (B) can be obtained by mixing the unsaturated polyester resin, a copolymerizable monomer and/or a copolymerizable prepolymer, and the thermoplastic resin. Although in general, it is possible to mix the copolymerizable monomer and/or the copolymerizable prepolymer, and the thermoplastic resin with the resin together with other materials during preparation of the resin composition, it is possible to mix it with the resin before the preparation of the resin composition. For the thermoplastic resin, it is possible to use a method wherein a powder or a granular material is used as it is, or a method wherein a liquid state is used wherein the copolymerizable monomer and/or the copolymerizable prepolymer are solved in advance.

In a preferred embodiment of the surface-mount-type light-emitting device with a reflector made by molding the unsaturated polyester resin composition according to the present invention can contain the use of the mixture between the unsaturated polyester resin (A) and the unsaturated polyester resin (B). In this case, the separately prepared unsaturated polyester resin (A) and unsaturated polyester resin (B) may be mixed and used, as shown in the following, the unsaturated polyester resin (B) may contain a crystalline unsaturated polyester.

In a preferred embodiment of the surface-mount-type light-emitting device with a reflector made by molding the unsaturated polyester resin composition according to the present invention, it is characterized in that the unsaturated polyester resin (B) comprises at least crystalline unsaturated polyester resin. An amount etc., of the thermoplastic resin is not particularly limited to, but in a preferred embodiment, it is in a range that 99 to 50 part by weight of a mixture comprising 35 to 95 part by weight of the unsaturated polyester containing a crystalline unsaturated polyester and 65 to 5 part by weight of a copolymerizable monomer and/or a copolymerizable prepolymer, and 1 to 50 part by weight of the thermoplastic resin, preferably 97 to 60 part by weight of a mixture comprising 35 to 95 part by weight of the unsaturated polyester containing a crystalline unsaturated polyester and 65 to 5 part by weight of a copolymerizable monomer and/or a copolymerizable prepolymer, and 3 to 40 part by weight of the thermoplastic resin, more preferably, 97 to 70 part by weight of a mixture comprising 35 to 95 part by weight of the unsaturated polyester containing a crystalline unsaturated polyester and 65 to 5 part by weight of a copolymerizable monomer and/or a copolymerizable polymer, and 3 to 30 part by weight of the thermoplastic resin. There is a possibility that in the case that a ratio of the thermoplastic resin is too small, a shrinkage becomes large and an image clarity becomes low, in the case that it is too many, there is a possibility that a reflectance after a test for heat resistance becomes low.

Although the above explanation is for the case of the use of the unsaturated polyester resin (A) or (B), the common matter of the unsaturated polyester resin (A) and (B) will be explained as follows.

In a preferred embodiment of the surface-mount-type light-emitting device with a reflector made by molding the unsaturated polyester resin composition according to the present invention, from a viewpoint of a moldability, a reflectance after a test for heat resistance, the unsaturated polyester resin (A) and / or (B) are / is from 10 to 35 percent by weight for total amount of composition, a total amount of an inorganic filler and a white pigment is from 50 to 80 percent by weight for total amount of composition, from a viewpoint of an initial reflectance, a reflectance after a test for heat resistance, a ratio of the white pigment in total amount of the inorganic filler and the white pigment is 10 to 50 percent by weight. Further, from a viewpoint of a cost of the white pigment and a catalytic effect, and further a high viscosity of the resin composition because it becomes a smaller particle diameter than those of the inorganic filler, a ratio of the white pigment in the total amount of the inorganic filler and the white pigment is more preferably from 10 to 29 percent by weight.

A formulation ratio of the crystalline unsaturated polyester resin is preferably from 10 to 35 percent by weight for a total amount of the composition. Because there is a possibility that a flowability reduces and a moldability becomes worse in the case that it is less than 10 percent by weight, and there is a possibility that a heat resistance reduces in that case that it is more than 35 percent by weight.

Moreover, in a preferred embodiment of the unsaturated polyester resin composition used for the surface-mount-type light-emitting device according to the present invention, it is characterized in that the unsaturated polyester resin (A) and (B) are a solid state in a temperature range of 50°C or less from a viewpoint of a dimensional stability in storage, a handleability and a workability. That is, it is a solid state in a temperature range from a room temperature or more to 50°C or less, and a grinding process or an extrusion and pelletizing process can be carried out.

Moreover, in a preferred embodiment of the unsaturated polyester resin composition used for the surface-mount-type light-emitting device according to the present invention, it is characterized in that regarding an amount of a copolymerizable monomer and/or a copolymerizable prepolymer capable of being used in the unsaturated polyester resin (A) and / or (B), a copolymerizable monomer of a liquid state at a room temperature is 50 percent by weight or more for total amount of a copolymerizable monomer and/or a copolymerizable prepolymer. The use of the crystalline unsaturated polyester as an unsaturated polyester resin makes it possible to produce an advantage that a solid state of an unsaturated polyester resin composition in a temperature range of 50 °C or less is obtained even if a 50 percent by weight or more of a copolymerizable monomer of a liquid state at a room temperature for total amount of a copolymerizable monomer and/or a copolymerizable prepolymer is used.

The crystalline unsaturated polyester capable of using for the unsaturated polyester resin composition used in the surface-mount-type light-emitting device according to the present invention, is no compatibility with acetone, styrene monomer etc., at a room temperature and the crystalline unsaturated polyester resin comprising a mixture formulated with a crystalline unsaturated polyester, a copolymerizable monomer and/or a copolymerizable prepolymer and a thermoplastic resin is also a solid state at a room temperature. It's property is that the crystalline unsaturated polyester does not solve if acetone, styrene monomer etc., is added to the crystalline unsaturated polyester at a room temperature. On the other hand, the amorphous unsaturated polyester is compatibility with acetone, styrene monomer etc., and it's property is that it becomes liquid state if acetone, styrene monomer etc., is added to the amorphous unsaturated polyester, a mixture of the amorphous unsaturated polyester and a copolymerizable monomer and/or a copolymerizable prepolymer is a liquid state of resin.

An unsaturated polyester is obtained by reacting with an unsaturated polybasic acid, a saturated polybasic acid and glycols according to a known dehydration condensation reaction, and thereby having an acid value of 5 to 40 mg-KOH/g generally.
It is possible to obtain an unsaturated polyester having a crystalline by selecting an acid component or a combination of an unsaturated polybasic acid, a saturated polybasic acid, and selecting or combining glycols, and selecting a ratio of formulation thereof accordingly in a manufacture of an unsaturated polyester.

As an unsaturated polybasic acid, mention may be made of maleic acid, maleic anhydride, fumaric acid, citraconic acid, mesaconic acid, itaconic acid, tetrahydrophthalic acid, tetrahydrophthalic anhydride, methyltetrahydrophthalic anhydride, glutaconic acid.

As a saturated polybasic acid, mention may be made of phthalic acid, phthalic anhydride, isophthalic acid, terephthalic acid, succinic acid, adipic acid, sebacic acid, azelaic acid, tetrahydrophthalic anhydride, methyltetrahydrophthalic anhydride, endo methylene - tetra - hydro phthalic anhydride, HET acid, tetrabromophthalic anhydride etc.

As glycols, mention may be made of ethylene glycol, 1,3 - propanediol, 1,4 - butanediol, 1,5 - pentanediol, 1,6 - hexanediol, propylene glycol, diethylene glycol, triethylene glycol, dipropylene glycol, neopentyl glycol, 1,3 - butanediol, bisphenol-A hydride, bisphenol-A propylene oxide compound, cyclohexanedimethanol, dibromo neopentyl glycol etc.

In the unsaturated polyester resin composition capable of being used in the surface-mount-type light-emitting device according to the present invention, among a crystalline unsaturated polyester, a crystalline unsaturated polyester is preferable wherein fumaric acid is used as an unsaturated polybasic acid, isophthalic acid or terephthalic acid is used as a saturated polybasic acid, ethylene glycol, 1,3-propanediol, 1,4 - butanediol, 1,5 - pentanediol, 1,6 - hexanediol, cyclohexanedimethanol are used as a primary component of glycol.

In the unsaturated polyester resin composition capable of being used in the surface-mount-type light-emitting device according to the present invention, as a copolymerizable monomer mixed with the unsaturated polyester according to the present invention, for example, mention may be made of vinyl aromatic compound such as styrene monomer, α- methylstyrene, vinyl toluene, α- chlorostyrene which have a vinyl group; vinyl ester such as vinyl acetate, vinyl propionate, vinyl lactate, vinyl butyrate, VeoVa monomer (Shell Chemicals Japan Ltd.); (meta) acrylic ester such as methyl acrylate, ethyl acrylate, n-butyl acrylate, methyl methacrylate, ethyl methacrylate, n-butyl methacrylate etc.

Moreover, it is possible to use a copolymerizable monomer with two functional or more such as triacyl cyanurate, diethylene glycol dimethacrylate, diallyl tetrabromo phthalate, phenoxyethyl acrylate, 2- hydroxyethyl acrylate, 1,6- hexanediol diacrylate etc. Further, it is possible to use a copolymerizable monomer with two functional or more which is a solid state at a room temperature, such as polyethyleneglycol di(meta)acrylate, ethoxylated isocyanuric acid triacrylate, pentaerythritol tetraacrylate etc. These copolymerizable monomer may be used by itself or by the combination of two or more thereof.

In the unsaturated polyester resin composition capable of being used in the surface-mount-type light-emitting device according to the present invention, it is possible to use a liquid state of a copolymerizable monomer and a solid state of a copolymerizable monomer at a room temperature as a copolymerizable monomer. In the unsaturated polyester resin composition containing a crystalline unsaturated polyester capable of being used in the surface-mount-type light-emitting device according to the present invention, a copolymerizable monomer of a liquid state at a room temperature for total amount of a copolymerizable monomer and/or a copolymerizable prepolymer is preferably 50 percent by weight or more. The use of 50 percent by weight or more of a copolymerizable monomer of a liquid state at a room temperature for total amount of a copolymerizable monomer and/or a copolymerizable prepolymer makes it possible to pack a filler contained in a resin composition highly and thereby improving a heat resistance. A ratio of a copolymerizable monomer of a liquid state at a room temperature for total amount of a copolymerizable monomer and/or a copolymerizable prepolymer is preferably 70 percent by weight or more, more preferably 90 percent by weight or more. The specific explanation is as follows, in the case of the unsaturated polyester resin comprising 80 part by weight of unsaturated polyester and 20 part by weight of a copolymerizable monomer and/or a copolymerizable prepolymer, a copolymerizable monomer of a liquid state at a room temperature is 10 part by weight or more, preferably 14 part by weight or more, more preferably 18 part by weight or more. There is a possibility that in the case that a copolymerizable monomer of a liquid state at a room temperature for total amount of a copolymerizable monomer and/or a copolymerizable prepolymer is less than 50 percent by weight, it becomes difficult to fill a filler contained in a resin composition highly and thereby reducing a heat resistance. It is possible to use, in particular, styrene monomer, methyl methacrylate, diethylene glycol dimetaacrylate preferably. Since an amorphous unsaturated polyester resin composition comprising an amorphous unsaturated polyester and a copolymerizable polymer of a liquid state at a room temperature has a low drying property by set to the touch, there is a possibility that a workability and a dimensional stability in storage a reduce. Moreover, it is possible to use a copolymerizable polymer in a range that does not impair a flowability during molding. It is possible to use a diallyl phthalate prepolymer etc., as a copolymerizable prepolymer.

It is possible to formulate an inorganic filler in the unsaturated polyester resin composition capable of being used in the surface-mount-type light-emitting device according to the present invention. Although as an inorganic filler, mention may be made of calcium carbonate, magnesium carbonate, barium carbonate, calcium hydroxide, aluminum hydroxide, magnesium oxide, mica, silica, aluminum oxide, but from a viewpoint of reflectance , calcium carbonate, aluminum hydroxide among them is preferable. These may be used by itself or a combination of two or more.

The average particle diameter of the inorganic filler is used within a range from 0.1 to 50 µm, preferably from 0.1 to 20 µm. The average particle diameter is measured by a median size or a measurement of a geometric average value according to a laser diffraction /scattering type of a device of measuring a particle size distribution. However, there are possibility that the average particle diameter is different according to the used method of calculating. The use of the inorganic filler having an average particle diameter makes it possible to obtain the unsaturated polyester resin for an LED reflector having a superior flowability for molding, a superior heat discoloration resistance and reflectance.

Furthermore, in a preferred embodiment of the unsaturated polyester resin composition capable of being used in the surface-mount-type light-emitting device according to the present invention, it is characterized in that the white pigment is at least one or more selected from a group of titanium oxide, barium titanate, barium sulfate, zinc oxide, zinc sulfide. In the present invention, among these white pigment, from a viewpoint of a reflectance, in particular, it is possible to use titanium oxide preferably.
As titanium oxide, for example, mention may be made of an anatase type of titanium oxide, a rutile type of titanium oxide, a brookite type of titanium oxide. Among them, a rutile type of titanium oxide having a superior heat stability can be preferably used. It is also possible to use any titanium oxide surface treated by a treating agent, as long as the objects of the present invention are not impaired.

Moreover, in a preferred embodiment of the unsaturated polyester resin composition capable of being used in the surface-mount-type light-emitting device according to the present invention, it is characterized in that the average particle diameter of the white pigment is 2.0 µm or less. Moreover, the average particle diameter of the white pigment is preferably 2.0 µm or less, more preferably from 0.01 to 1.0 µm, further more preferably from 0.1 to 0.5 µm from a viewpoint of a reflectance. The average particle diameter is calculated by a measurement of an initial particle using an electron microscope. Moreover, there is possibility that a superior moldability can not be obtained and thereby it being impossible to obtain a high reflectance in the case that an average particle diameter of the white pigment is large.

Moreover, in the unsaturated polyester resin composition capable of being used in the surface-mount-type light-emitting device according to the present invention, a reinforcing material can be formulated. The use of the reinforcing material makes it possible to obtain an unsaturated polyester resin composition for an LED reflector having a superior strength characteristic, dimensional stability.

Although as a reinforcing material, in general, glass fibers can be used which is used as a reinforcing material of an unsaturated polyester resin composition used for a fiber-reinforced plastic (FRP) such as a bulk molding compound (BMC), a sheet molding compounds (SMC), it is not limited to glass fibers, but those other than the glass fibers can be also used. Although as a reinforcing material used for other than the glass fibers, mention may be made of carbon fibers, an inorganic fibers such as whiskers, an organic fibers such as aramid fibers or polypropylene fibers, aramid fibers or polypropylene fibers is preferable.

As glass fibers, mention may be made of glass fibers such as E glass (non - alkali glass fibers for electricity) wherein the raw material is silicate glass, borosilicate glass, C glass (alkali glass fibers for chemistry), A glass (acid-resistant glass), S glass (high-strength glass), those of continuous fibers (roving), discontinuous fibers (chopped strands) can be used. Further, those of the surface-treated these glass fibers can be also used.

Among them, from a viewpoint of a size and shape of molded articles, the use of the discontinuous fibers (chopped strands) is preferable. Moreover, in the case of a long length type of glass fibers such as a woven material or a nonwoven fabric, it is difficult to uniformly mix it with other resin composition, that is, the unsaturated polyester resin, the white pigment and the inorganic filler etc. Further, it is difficult to fill the composition to the end of minute and complicated molded articles since long glass fibers make flowability of a resin composition poor. In the case that an L/D (a ratio of a length of fiber for a diameter of fiber) is small, a stiffening effect as a reinforcing material is not attained. A preferable length of fiber of the reinforcing material used in the present invention is in a range from 3 to 6 mm, and a diameter of fiber is in a range from 6 to 15 µm.

In the unsaturated polyester resin composition capable of being used in the surface-mount-type light-emitting device according to the present invention, it is possible to use a thermolysis type of an organic peroxide as a polymerization initiator or a polymerization inhibitor which is generally used to the unsaturated polyester resin composition.

As an organic peroxide, mention may be made of t - butylperoxy - 2-ethylhexyl monocarbonate, 1,1-di(t-hexylperoxy) cyclohexane, 1,1-di(t-butylperoxy)- 3,3,5 - trimethyl cyclohexane, t - butyl peroxyoctoate, benzoyl peroxide, methyl ethyl ketone peroxide, acetylacetone peroxide, t - butylperoxy benzoate, dicumyl peroxide etc. These may be used by itself or by the combination of two or more thereof.

Among them, from a viewpoint of molding conditions, stability of storage, the use of organic peroxide wherein the 10 hours half-life temperature is 100 °C or more, is preferable, and specifically dicumyl peroxide can be used preferably.

As a polymerization inhibitor, mention may be made of quinones such as hydroquinone, monomethyl ether hydroquinone, toluhydroquinone, di - t - 4 - methylphenol, monomethyl ether hydroquinone, phenothiazine, t- buthyl catechol, parabenzoquinone, pyrogallol, a phenolic compound such as 2,6 - di - t - butyl - cresol, 2,2-methylene - bis - (4 - methyl - 6 - t - butyl phenol), 1,1,3 - tris - (2 - methyl - 4 - hydroxyl - 5 - t - butyl phenyl) butane. These may be used by itself or by the combination of two or more thereof.

Moreover, it is possible to formulate other inorganic filler appropriately to the unsaturated polyester resin composition capable of being used in the surface-mount-type light-emitting device according to the present invention in a range keeping features such as a flowability of a resin composition or a reflectance when it is molded to an LED reflector.

As these type of other inorganic filler, mention may be made of an empty particle such as an oxide or hydrate thereof, an inorganic bubble particle, a silica balloon etc.

It is possible to use a release agent in the unsaturated polyester resin composition capable of being used in the surface-mount-type light-emitting device according to the present invention. As a release agent, mention may be made of waxes such as fatty acid type, fatty acid metal salt type, mineral type etc., which is generally used for a thermosetting resin, in particular, it is possible to preferably use those of fatty acid type, fatty acid metal salt type of waxes which is superior for a heat discoloration resistance.

As these release agent, specifically mention may be made of stearic acid, zinc stearate, aluminum stearate, calcium stearate. These release agent may be used by itself or by the combination of two or more thereof.

These release agent can be formulated with 3 to 15 parts by weight for 100 parts by weight of the unsaturated polyester resin. This range of the formulated amount of the release agent makes it possible to keep a good property of mold release. In the case that it is too small, there is possibility that a property of mold release between a die and a molded article becomes low and thereby reducing a productivity extremely, and in the case that it is too much, there is possibility that a sealant cannot be attached firmly. Since there is no need to coat the release agent to the die by means of the formulation of the release agent to the composition in advance, it is possible to apply it to a molding method such as an injection molding wherein a molding cycle is short.

In the unsaturated polyester resin composition capable of being used in the surface-mount-type light-emitting device according to the present invention, other than these components, according to need, it is possible to accordingly formulate a curing catalyst and a polymerization inhibitor in order to control a curing condition of the unsaturated polyester resin composition, a colorant, a thickener, a light stabilizer, a processing stabilizer, an ultraviolet absorber, a nucleating agent, a fluorescent brightening agent, a fire retardant, a photopolymerization initiator, an antibacterial agent, an antistatic agent, a foaming agent, a surfactant, a surface modifier, a coupling agent, the other organic series additive agent and inorganic additive agent.

The unsaturated polyester resin composition capable of being used in the surface-mount-type light-emitting device according to the present invention can be manufactured by formulating each components to mix it adequately and uniformly by using a mixer, a blender and after that, to control and granulate by using a mixer, an extruder capable of applying heat and pressure. Since in the case that a glass woven fabric is used as a reinforcement, it is possible to mix and granulate adequately by using a mixer, an extruder, and in the case that nonwoven glass fabric is used, it is impossible to keep a shape of nonwoven fabric because a sheet type of nonwoven fabric is destroyed during mixture, it cannot find out a superiority of the use of woven fabric and nonwoven fabric.

Furthermore, the unsaturated polyester resin composition capable of being used in the surface-mount-type light-emitting device according to the present invention can be a granular material. The granular material comprising the crystalline unsaturated polyester resin composition may be a fine particle obtained by grinding the composition or a pellet form.

Furthermore, the unsaturated polyester resin composition capable of being used in the surface-mount-type light-emitting device according to the present invention is a dry type and a good heat stability during melting, it is possible to use preferably a melt-heat molding process such as an injection molding process, an injection compression molding process, transfer molding process etc., since in a laminated sheet using a glass woven fabric or a nonwoven glass fabric as a reinforcement, it is needed to impregnate the resin composition into a woven fabric or a nonwoven fabric in advance, the resin composition must be a liquid state, and therefore, it is different characteristic comparing with the unsaturated polyester resin composition capable of being used in the surface-mount-type light-emitting device according to the present invention. The molding process is limited to a pressure molding process using a press.

Among them, the injection molding process using an injection molding machine is preferably, the use of injection molding process makes it possible to further shorten a time for molding cycle and to manufacture an LED reflector having a complicated shape for mounting a light emitting element, different from a tabular laminated sheet.

A viscosity of the unsaturated polyester resin composition was measured by using a viscosity measuring instrument (capillary rheometer).

Moreover, a preferred embodiment of the unsaturated polyester resin composition capable of being used in the surface-mount-type light-emitting device according to the present invention, it is characterized in that a degree of viscosity of the resin composition is in a range from 0.1 to 100kPa-s. In the case that the viscosity of the resin composition is in this range, it is possible to keep a good moldability. There is a possibility that in the case that the viscosity is less than 0.1 kPa-s, it is easy to fill in excessive quantities and thereby generating defective product such as flash since a flowability in a die is superior. There is a possibility that in the case that the viscosity is more than 100 kPa-s, a defective product is generated by a shortage of filling, since a flowability in a die is worse.

Moreover, a preferred embodiment of the unsaturated polyester resin composition capable of being used in the surface-mount-type light-emitting device according to the present invention, it is characterized in that a degree of viscosity of the resin composition in a temperature range from 70 to 120°C is in a range from 0.1 to 100kPa-s. In the case that the temperature is less than 70 °C, it is difficult to mold by injection molding since the resin composition is not melted. Even if it is possible to mold by injection molding, there is possibility that it is impossible to fill the resin composition into the end of a die because of a high viscosity of the resin composition. On the other hand, in the case that it is more than 120 °C, a curing reaction occurs in a cylinder during molding, there is possibility that it is difficult to carry out a continuous molding. Even if it is possible to mold by injection molding, there is possibility that the injected resin composition into a die flows back, and it is impossible to fill the resin composition into the end of a die. In order to fill it into the end of a die, if a volume of injection increases, there is possibility that a flash becomes large during molding because the viscosity of the resin composition is low. From the above reason, a degree of viscosity of the unsaturated polyester resin composition for an LED reflector is preferably in a range from 0.1 to 100kPa-s in a temperature range from 70 to 120°C.

A gel time of the unsaturated polyester resin composition was measured by a heat - pressure molding using a die with a differential transformer type position sensor. After the resin composition is set into the die, although a differential transformer stops (inflexion point 1) at a time that the die is clamped (the die with a differential transformer type position sensor) is raised up and it becomes a constant thickness, but an S-curve of displacement - time was obtained wherein since a hardening shrinkage begins according to the progress of hardening, a position of the differential transformer starts moving upward again (inflexion point 2). A time between an inflexion point 1 and an inflexion point 2 is defined as a gel time.

Moreover, in a preferred embodiment of the unsaturated polyester resin composition capable of being used in the surface-mount-type light-emitting device according to the present invention, it is characterized in that a gel time of the unsaturated polyester resin composition in a temperature range from 140 to 180°C is in a range of 5 to 120 sec. There is a possibility that in the case that a gel time of the unsaturated polyester resin composition in a temperature range from 140 to 180°C is less than 5 sec, because a gelation of the resin composition occurs before it is filled into a cavity of the die, it is impossible to transcribe a surface of the die adequately and to obtain a molded article having a good surface smoothness. There is possibility that in the case that a gel time of the unsaturated polyester resin composition in a temperature range from 140 to 180°C is more than 120 sec, since it is need to take a long time to cure, a productivity becomes worse and it is impossible to become widely used as a general reflector.

It is important that a curing speed such as a gel time etc., is controlled in order to obtain a molded article having a superior quality. There is a possibility that in the case that a gel time is too short, since a gelation of the resin composition occurs before it is filled into a cavity of the die, it is impossible to transcribe a surface of the die adequately and to obtain a molded article having a good surface smoothness. On the other hand, there is a possibility that in the case that a gel time is too long, since it is need to take a long time to cure, a productivity becomes worse and it is impossible to become widely used as a general reflector.

A preferred embodiment of the unsaturated polyester resin composition capable of being used in the surface-mount-type light-emitting device according to the present invention is a method of an injection molding wherein the unsaturated polyester resin composition for an LED reflector is heated and cured at from 140 to 180 °C (a die temperature). There is a possibility that in the case that a die temperature is less than 140 °C, since it is need to take a long time to cure because of the slow speed of curing, a productivity becomes worse and it is impossible to become widely used as a general reflector. There is a possibility that in the case that a die temperature is more than 180 °C, it is impossible to obtain a product because a speed of curing is high and it tends to become a shortage of filling at the end portion.

### (The surface-mount-type light-emitting device)

The surface-mount-type light-emitting device according to the present invention is a light-emitting device with a reflector made by molding an unsaturated polyester resin composition. The surface-mount-type light-emitting device according to the present invention is used for a light source for an illumination, a light source for an automobile, a light source for a backlight

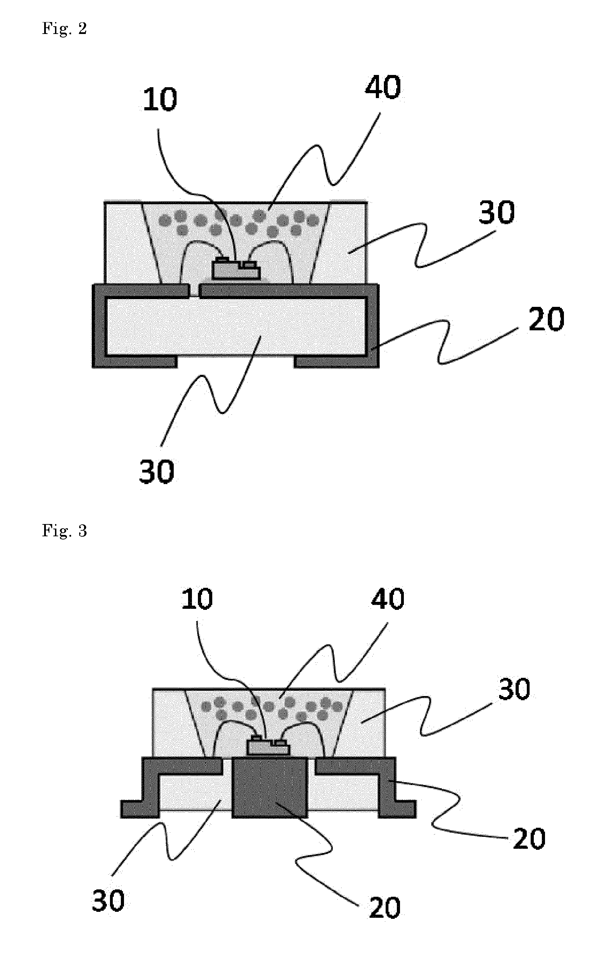

An example of a representative constitution of the surface-mount-type light-emitting device according to the present invention. Fig. 2 gives a pattern diagram of a wire bonding type of a surface-mount-type light-emitting device 1. The surface-mount-type light-emitting device 1 shown in Fig. 2 is a device wherein a semiconductor light emitting element 10 is arranged to a concavity portion shape of a reflector (housing) 30 molded together with a lead frame 20, and a sealant 40 (light transmittance state of thermosetting resin) is filled in a concavity portion (cup-shaped portion) of the reflector 30.

The explanation of each component of the surface-mount-type light-emitting device according to the present invention is as follows. The surface-mount-type light-emitting device according to the present invention is not limited to the following component.

### (The semiconductor light emitting element)

As the semiconductor light emitting element 10, those of 500 nm or less of a wave length of a luminescence peak is preferably used. As a semiconductor light emitting element, it is possible to use not only a semiconductor light emitting element having a single luminescence peak, but a semiconductor light emitting element having a multiple luminescence peak such as a single or a multiple luminescence peak at an area of a 500 nm or more of a longer wave length.

The semiconductor light emitting element 10 can be used without being not particularly limited to, as long as it has the above luminescence peak. As a semiconductor formed as a luminescent layer, mention may be made of GaAIN, ZnS, ZnSe, SiC, GaP, GaAlAs, AlN, InN, AlInGaP, InGaN, GaN, AlInGaN.

It is possible to use one or more of the semiconductor light emitting element 10 according to need. For example, it is possible to combine one or more of each light emitting element capable of emitting ultraviolet light, near-ultraviolet light, blue light, green light and red light, in order to obtain the white light.

A method of connecting the semiconductor light emitting element 10 to the lead frame 20. It is possible to use an epoxy type, or a silicone type or these hybrid type of an electrically conductive adhesive agent, or a metal having a low melting point such as Sn/Ag/Cu (220°C of a melting point), Sn/Au (282°C of a melting point).

### (The lead frame)

The lead frame 20 is a metal frame wherein a die pad for fixing the semiconductor light emitting element and an extraction wiring are formed. As the lead frame, a bar of iron, copper base alloy can be used, and those of being treated a metallizing plating after a bar of iron is patterned by a stamping or an etching, can be also used.

### (The reflector)

The reflector 30 is a member loaded with the semiconductor light emitting element 10, a part of all of them is formed by the above unsaturated polyester resin composition.

It is preferable that the reflector 30 has a concavity portion (cup-shaped portion). As an example of the reflector 30, mention may be made of those of the combination of the lead frame 20, for example, in the surface-mount-type light-emitting device 1 of Fig. 2, a concavity portion (cup-shaped portion) is formed by molding a desired shape of the reflector 30 on the lead frame 20 by an adhesion or as a unit.

A concavity portion (cup-shaped portion) is formed so as to obtain a shape wherein a cross-section area thereof increases from the bottom toward to a direction of an extraction of light continuously or escalatory. As long as it satisfies with these conditions, a shape of a concavity portion (cup-shaped portion) is not particularly limited.

### (The sealant)

The sealant 40 is a member for coating the semiconductor light emitting element 10, an object thereof is mainly to protect the semiconductor light emitting element 10 or a wiring from an external environment.

As the sealant 40, a transparent thermosetting resin is used. As a transparent thermosetting resin, mention may be made of an epoxy resin, or a silicone resin, acrylate resin, urethane resin etc. Among them, an epoxy resin or a silicone resin having a superior heat resistance, light stability is preferable. Moreover, in order to enhance an adhesiveness between the reflector 30 and the sealant 40, a surface of the reflector 30 may be improved by the treatment of a corona discharge, plasma.

The sealant 40 can contain a fluorescent material. The existence of the fluorescent material of the sealant 40 makes it possible to convert a part of light from the semiconductor light emitting element 10 into a different wave length of light and thereby controlling a luminescent color of the surface-mount-type light-emitting device.

As a fluorescent material, it is possible to use any substances as long as it can be excited by light from semiconductor light emitting element 10. For example, it is preferably used at least one or more selected from a nitride fluorescent material, an acid nitride fluorescent material, a sialon series of fluorescent material which are mainly activated by an element of the lanthanoid system such as Eu, Ce etc.; an alkaline earth metal aluminate fluorescent material, an alkaline earth silicate, an alkaline earth sulfide, an alkaline earth thiogallate, an alkaline earth silicon nitride, a germinate which are mainly activated by an element such as the lanthanoid system such as Eu, or a transition metal system such as Mn etc., an alkaline earth aluminate, an alkaline earth silicate which are mainly activated by an element of the lanthanoid system such as Ce etc.; an organic compound and an organic complex which are mainly activated by an element of the lanthanoid system such as Eu etc. Moreover, the combination of a multiple kind of the fluorescent material may be contained in the sealant 40.

The sealant 40 can contain a light scattering material. The inclusion of the light scattering material makes it possible to produce luminescence of the semiconductor light emitting element 10, that is, point light source, from the whole area of the concavity portion of the reflector 30, and thereby reducing the lack in uniformity. As the light scattering material, mention may be made of titanium oxide, zinc oxide, barium titanate and aluminum oxide.

A surface-mount-type light-emitting device 1 of Fig. 2, for example is manufactured as follows. At first, the lead frame 20 is inserted to obtain a reflector 30 wherein the unsaturated polyester resin composition is injection molded. Next, the semiconductor light emitting element 10 is mounted to connect an electrode of the semiconductor light emitting element 10 and a wiring pattern on the lead frame 20 to the concavity portion within the reflector by the bonding wire. Next, the fluorescent material is mixed with the liquid state of the silicone sealant comprising a base resin and a curing agent to carry out potting to the concavity portion within the reflector. In this state, the silicone sealant is heated at about 150 °C to cure by heat. After that, it is radiated heat in the air.

Fig. 3 gives a pattern diagram as an example of a light-emitting device 2 comprising other constitution according to an embodiment of the present invention. In Fig. 3, the same symbol is given to the same element of the surface-mount-type light-emitting device 1. In the surface-mount-type light-emitting device 2, a heat sink is attached to the lead frame 20. Other constitution is the same as the surface-mount-type light-emitting device 1.

As mentioned above, although as an example of the constitution of the present invention, a wire bonding type of a surface-mount-type light-emitting device is explained, the present invention can be applicable for a flip chip type of a surface-mount-type light-emitting device wherein the semiconductor light emitting element is mounted with so called flip chip shape on the substrate or the lead frame.

### (The lighting device)

The present invention is also a lighting device equipped with a surface-mount-type light-emitting device. The lighting device of the present invention is a longer operating life because it uses the above light-emitting device having a longer operating life. The lighting device of the present invention can be constituted according to the common method. For example, it is possible to be constituted by substituting the light-emitting device of the prior art used for a light source of the LED lightning device of the prior art with the above surface-mount-type light-emitting device.

### (The image display device)

The present invention is also an image display device equipped with the above surface-mount-type light-emitting device (for example, a small display of a cell-phone etc., or small display of a digital camera, a digital video camera, a car navigation system etc., or medium size or large size of display of a personal computer, a liquid crystal display television. The image display device of the present invention is a longer operating life because it uses the above light-emitting device having a longer operating life. The image display device of the present invention can be constituted according to the common method. For example, it is possible to be constituted by substituting the light-emitting device of the prior art used for a light source for an LED back light in the image display device of the prior art with the above surface-mount-type light-emitting device.

### Example

As mentioned below, an embodiment of the present invention will be concretely explained in more detail with reference to Examples, but the invention is not intended to be interpreted as being limited to Examples.

### (Example of manufacturing the unsaturated polyester resin composition)

### Examples 1 to 30, and Comparative examples 1 to 2

An unsaturated polyester resin composition for an LED reflector described in the Examples 1 to 13 shown in the table 2 and described in the Examples 14 to 30 shown in the table 3, and an amorphous unsaturated polyester resin composition for an LED reflector described in the Comparative examples 1 to 2 shown in table 4, were formulated with the formulation amount described in the following table 2, 3 and 4, and prepared uniformly using a neader capable of heating and pressuring and after that, the prepared mixture was fed into the extruder to granulate and obtain a resin composition.

The obtained unsaturated polyester resin composition was molded by injection molding machine under the conditions of a die temperature of 165 °C and a curing time of 60 sec to obtain a test piece. The physical property evaluation of the molded test piece was carried out by the below mentioned method and was shown in the tables 2, 3 and 4, respectively.

The following components of the formulation were used.

### (1) An unsaturated polyester resin

1. An unsaturated polyester resin 1: a crystalline unsaturated polyester resin (T-855, made by Japan U-Pica Company, Ltd.)
2. An unsaturated polyester resin 2: an amorphous unsaturated polyester resin (T-8552, made by Japan U-Pica Company, Ltd)
3. A copolymerizable monomer 1: styrene monomer (made by Asahi Kasei Corporation)
4. A copolymerizable monomer 2: diethylene glycol dimethacrylate (NK ester 2G, made by Shin Nakamura Chemical Co., Ltd)
5. A copolymerizable monomer 3: ethoxylated isocyanuric acid triacrylate (A-9300 made by Shin Nakamura Chemical Co., Ltd)
6. A copolymerizable prepolymer: diallyl phthalate prepolymer (DAP polymer made by Daiso Co., Ltd.)
7. A thermoplastic resin 1: polymethyl methacrylate (MG515, Shanghai Jing Qi Polymer Materials Co., Ltd.)
8. A thermoplastic resin 2: polystyrene (GPPS679 made by Asahi Kasei Corporation)
9. A thermoplastic resin 3: polystyrene (PR-1050 made by Tokyo Printing Ink Mfg. Co., Ltd.)

### (2) A white pigment

1. A white pigment : titanium oxide (rutile type titanium oxide, an average particle diameter :0.2µm) (CR-60 made by ISHIHARA SANGYO KAISHA, LTD.)

### (3) An inorganic filler

1. An inorganic filler 1: calcium carbonate (an average particle diameter: 2 µm)
2. An inorganic filler 2: aluminum hydroxide (an average particle diameter: 10 µm)
3. An inorganic filler 3: silica (an average particle diameter: 30 µm)

### (4) An additive agent

1. A reinforcement: glass fiber (CS 3 PE-908 made by NITTO BOSEKI CO., LTD.)
2. A release agent: zinc stearate (GF-200 made by NOF CORPORATION.)
3. A polymerization initiator: dicumyl peroxide (PERCUMYL™ D made by NOF CORPORATION.)

**[Table 1]**

| component | | **unit** | **crystalline unsaturated polyester resin** | amorphous unsaturated polyester resin |
|---|---|---|---|---|
| **crystalline unsaturated polyester** | | part by weight | **70** | |
| **amorphous unsaturated polyester** | | part by weight | | **70** |
| **styrene monomer** | | part by weight | **30** | **30** |
| liquid characteristic | **25°C** | **Pa·s** | **solid state** | **21.0** |
| | **50°C** | **Pa·s** | **solid state** | **1.8** |
| | **70°C** | **Pa·s** | **0.8** | **0.8** |

**[Table 2]**

| component | detailed component | unit | Exa.1 | Exa.2 | Exa.3 | Exa.4 | Exa.5 | Exa.6 | Exa.7 | Exa.8 | Exa.9 | Exa.10 | Exa.11 | Exa.12 | Exa.13 |
|---|---|---|---|---|---|---|---|---|---|---|---|---|---|---|---|
| unsaturated polyester resin | crystalline unsaturated polyester | part by weight | 70 | 70 | 70 | 70 | 50 | 90 | 70 | 70 | 70 | 70 | 70 | 80 | 60 |
| | amorphous unsaturated polyester | part by weight | | | | | | | | | | | | | 10 |
| | styrene monomer | part by weight | 30 | 30 | 30 | 30 | 50 | 10 | 15 | 20 | 30 | 30 | 30 | 20 | 30 |
| | diethylene glycol dimethacrylate | part by weight | | | | | | | 15 | | | | | | |
| | ethoxylated isocyanuric acid triacrylate | part by weight | | | | | | | | 10 | | | | | |
| white pigment | titanium oxide | part by weight | 100 | 75 | 50 | 200 | 120 | 50 | 100 | 100 | 100 | 100 | 25 | 35 | 100 |
| inorganic filler | calcium carbonate | part by weight | 250 | 300 | 350 | 100 | 425 | 125 | 250 | 250 | 50 | | 325 | 90 | 250 |
| | aluminum hydroxide | part by weight | | | | | | | | | 200 | 250 | | | |
| additive agent | glass fiber | part by weight | 80 | 80 | 80 | 80 | 50 | 30 | 80 | 80 | 80 | 80 | 80 | 30 | 80 |
| | zinc stearate | part by weight | 6 | 6 | 6 | 6 | 6 | 6 | 6 | 6 | 6 | 6 | 6 | 6 | 6 |
| | dicumyl peroxide | part by weight | 5 | 5 | 5 | 5 | 5 | 5 | 5 | 5 | 5 | 5 | 5 | 5 | 5 |
| physical property | granulatability | | ○ | ○ | ○ | ○ | ○ | ○ | ○ | ○ | ○ | ○ | ○ | ○ | ○ |
| | initial reflectance | % | 97 | 95 | 91 | 98 | 92 | 97 | 97 | 96 | 94 | 94 | 88 | 94 | 97 |
| | reflectance after test for heat resistance | % | 88 | 85 | 82 | 90 | 85 | 80 | 88 | 88 | 85 | 85 | 78 | 75 | 88 |
| | dimensional stability in storage | | ○ | ○ | ○ | ○ | ○ | ○ | ○ | ○ | ○ | ○ | ○ | ○ | ○ |
| comprehensive evaluation | | | ○ | ○ | ○ | ○ | ○ | ○ | ○ | ○ | ○ | ○ | Δ | Δ | ○ |

**[Table 3]**

| component | detailed component | unit | Exa.14 | Exa.15 | Exa.16 | Exa.17 | Exa.18 | Exa.19 | Exa.20 | Exa.21 | Exa.22 | Exa.23 | Exa.24 | Exa.25 | Exa.26 | Exa.27 | Exa.28 | Exa.29 | Exa.30 |
|---|---|---|---|---|---|---|---|---|---|---|---|---|---|---|---|---|---|---|---|
| unsaturated polyester resin | crystalline unsaturated polyester | part by weight | 67 | 60 | 35 | 60 | 60 | 45 | 70 | 60 | 60 | 60 | 60 | 60 | 70 | 60 | 50 | 30 | |
| | amorphous unsaturated polyester | part by weight | | | | | | | | | | | | | | | 10 | 30 | 60 |
| | styrene monomer | part by weight | 30 | 30 | 40 | 30 | 30 | 50 | 10 | 15 | 20 | 30 | 30 | 30 | 20 | 30 | 30 | 15 | 15 |
| | diethylene glycol dimethacrylate | part by weight | | | | | | | | 15 | | | | | | | | | |
| | ethoxylated isocyanuric acid triacrylate | part by weight | | | | | | | | | 10 | | | | | | | 5 | 5 |
| | polymethyl methacrylate | part by weight | 3 | 10 | 25 | 10 | 10 | 5 | 20 | 10 | 10 | 10 | 10 | 10 | 10 | | 10 | | |
| | polystyrene | part by weight | | | | | | | | | | | | | | 10 | | | |
| | polyethylene | part by weight | | | | | | | | | | | | | | | | 20 | 20 |
| white pigment | titanium oxide | part by weight | 100 | 100 | 100 | 160 | 200 | 120 | 50 | 100 | 100 | 100 | 100 | 25 | 35 | 100 | 100 | 100 | 100 |
| inorganic filler | calcium carbonate | part by weight | 250 | 250 | 250 | 160 | 100 | 425 | 125 | 250 | 250 | 50 | | 325 | 90 | 250 | 250 | 250 | 250 |
| | aluminum hydroxide | part by weight | | | | | | | | | | 200 | 250 | | | | | | |
| additive agent | glass fiber | part by weight | 80 | 80 | 80 | 80 | 80 | 50 | 30 | 80 | 80 | 80 | 80 | 80 | 30 | 80 | 80 | 80 | 80 |
| | zinc stearate | part by weight | 6 | 6 | 6 | 6 | 6 | 6 | 6 | 6 | 6 | 6 | 6 | 6 | 6 | 6 | 6 | 6 | 6 |
| | dicumyl peroxide | part by weight | 5 | 5 | 5 | 5 | 5 | 5 | 5 | 5 | 5 | 5 | 5 | 5 | 5 | 5 | 5 | 5 | 5 |
| physical property | granulatability | | ○ | ○ | ○ | ○ | ○ | ○ | ○ | ○ | ○ | ○ | ○ | ○ | ○ | ○ | ○ | ○ | ○ |
| | dimensional stability in storage | | ○ | ○ | ○ | ○ | ○ | ○ | ○ | ○ | ○ | ○ | ○ | ○ | ○ | ○ | ○ | ○ | Δ |
| | initial reflectance | % | 97 | 97 | 97 | 98 | 98 | 92 | 97 | 97 | 96 | 94 | 94 | 88 | 94 | 97 | 97 | 96 | 96 |
| | reflectance after test for heat resistance | % | 88 | 87 | 83 | 88 | 88 | 85 | 80 | 87 | 87 | 84 | 84 | 78 | 75 | 86 | 87 | 86 | 86 |
| | shrinkage of a molded article | % | 0.6 | 0.4 | 0.3 | 0.4 | 0.4 | 0.4 | 0.4 | 0.4 | 0.5 | 0.5 | 0.5 | 0.4 | 0.6 | 0.5 | 0.4 | 0.4 | 0.3 |
| | image clarity | % | 17 | 30 | 34 | 28 | 28 | 13 | 35 | 30 | 30 | 28 | 28 | 30 | 42 | 26 | 30 | 59 | 59 |
| comprehensive evaluation | | | ○ | ○ | ○ | ○ | ○ | ○ | ○ | ○ | ○ | ○ | ○ | Δ | Δ | ○ | ○ | ○ | Δ |

**[Table 4]**

| component | detailed component | unit | Com.1 | Com.2 |
|---|---|---|---|---|
| unsaturated polyester resin | amorphous unsaturated polyester | part by weight | 70 | 70 |
| | styrene monomer | part by weight | | 30 |
| | diallyl phthalate prepolymer | part by weight | 30 | |
| white pigment | titanium oxide | part by weight | 150 | 100 |
| inorganic filler | calcium carbonate | part by weight | | 250 |
| | silica | part by weight | 150 | |
| additive agent | glass fiber | part by weight | 55 | 80 |
| | zinc stearate | part by weight | 6 | 6 |
| | dicumyl peroxide | part by weight | 9 | 5 |
| physical property | granulatability | | Δ | Δ |
| | dimensional stability in storage | | Δ | × |
| | initial reflectance | % | 92 | 97 |
| | reflectance after test for heat resistance | % | 77 | 87 |
| | shrinkage of a molded article | % | 0.6 | 0.9 |
| | image clarity | % | 32 | 9 |
| comprehensive evaluation | | | × | × |

### <A resin property and a method of evaluating physical property>

### (1) A resin property of the unsaturated polyester resin

Under the conditions of 25°C, 50°C, and 70°C as shown in table 1, the viscosity of crystalline unsaturated polyester resin and amorphous unsaturated polyester resin were measured by viscometer (TVB-10 type of viscometer, rotor M2 made by TOKI SANGYO CO.,LTD). A measurement of viscosity of the solid state of crystalline unsaturated polyester resin was cancelled.

### (2) A granulatability

A strand was produced from the unsaturated polyester resin composition for an LED reflector mentioned in the Examples 1 to 13 shown in table 2 and in the Examples 14 to 30 shown in table 3 and the amorphous unsaturated polyester resin composition of the Comparison Examples 1 to 2 shown in table 4 by using the mixer and the extruder capable of heating and pressuring, to granulate them by hot cut.
The "○" shows a good granulated resin composition, the "Δ" shows a resin composition which is difficult to granulate, the "×" shows a resin composition which is impossible to granulate. The results of these are shown in tables 2, 3 and 4.

### (3) A dimensional stability in storage

2 kg of the unsaturated polyester resin composition for an LED reflector mentioned in the Examples 1 to 13 shown in table 2 and in the Examples 14 to 30 shown in table 3, and the amorphous unsaturated polyester resin composition of the Comparison Examples 1 to 2 shown in table 4 were put into a bag comprising a multilayer film of PE (polyethylene) /PET (polyethylene terephthalate) wherein a copolymerizable monomer does not permeate, and further the bag containing the resin composition was set in a 20 cm square of vessel to apply 10 kg of load to the whole area of the resin composition in the vessel and a dimensional stability of the resin composition was confirmed by storing them for two weeks in 50°C of the hot-air dryer. The "○" shows those of no change of shape, the "Δ" shows those of occurring a little bit change of shape, the "×" shows those of occurring change of shape. The results of these are shown in tables 2, 3 and 4. However, even if the above standard is not fulfilled, since there is possibility that conditions are adopted according to a desired application and a desired quality etc., even if there are the case of occurring a little bit change of shape, the standard may be thought that it is one of rough indication.

### (4) An initial reflectance

The reflectance of the test pieces of the Examples 1 to 13 shown in table 2, the Examples 14 to 30 shown in table 3 and the Comparison Examples 1 to 2 shown in table 4 were measured at 450 nm of measurement wavelength of the reflectance by using an ultraviolet, visible and near-infrared spectrophotometric (UV-3100PC made by SHIMADZU CORPORATION). The result of these are shown in tables 2, 3 and 4. The targeted initial reflectance is defined as 90% or more, those of 90% or more are good and those of less than 90% are defective. However, even if the above precise standard is not fulfilled, since there is possibility that conditions are adopted according to a desired application and a desired quality etc., even if it is less than 90%, the standard may be thought that it is one of rough indication.

### (5) A reflectance after test for heat resistance

The reflectance of the test pieces of the Examples 1 to 13 shown in table 2, the Examples 14 to 30 shown in table 3 and the Comparison Examples 1 to 2 shown in table 4 were kept for 1000 hours at the hot-air dryer controlled at 150°C, and were measured at 450 nm of measurement wavelength of the reflectance by using an ultraviolet, visible and near-infrared spectrophotometric (UV-3100PC made by SHIMADZU CORPORATION). The result of these are shown in tables 2, 3 and 4. The targeted reflectance after test for heat resistance is defined as 80% or more, those of 80% or more is good and those of less than 80% is defective. However, even if the above precise standard is not fulfilled, since there is possibility that conditions are adopted according to a desired application and a desired quality etc., even if it is less than 80%, the standard may be thought that it is one of rough indication.

### (6) A shrinkage of a molded article

The resin compositions of the Examples 14 to 30 shown in table 3 and the Comparison Examples 1 to 2 shown in table 4 were injected to a die wherein a temperature is controlled at 165°C, and were heated and pressured for 3 minutes. A molded pieces were immediately removed and kept under the conditions at 23 °C and 55 RH of humidity with constant temperature and humidity for 24 hours. Regarding a test piece with the outer shape of an umbonate encircling zone at both front and back, a size of total four places, specifically, two places of the front face and two places of the back face were measured along the measurement line crossing at right angles to one another. An outer shape of the flute of a die corresponding to a test piece was measured at the same conditions with accuracy of 0.01 mm to calculate a shrinkage of a molded article. The results of these are shown in table 3 and table 4. The targeted shrinkage of a molded article is defined as 0.6%, those of less than 0.6% are good and those of more than 0.6% are defective. However, even if the above precise standard is not fulfilled, since there is possibility that conditions are adopted according to a desired application and a desired quality etc., even if it is more than 0.6%, the standard may be thought that it is one of rough indication.

### (7) An image clarity

A test piece of the Examples 14 to 30 shown in table 3 and the Comparison Examples 1 to 2 shown in table 4 were measured by using a measuring instrument of an image clarity (ICM-2DP made by Suga Test Instruments Co., Ltd.) under the conditions that an optical comb is 1 mm. The results of these are shown in table 3 and table 4. The targeted image clarity is defined as 10%, those of 10 % or more is good and those of less than 10% is defective.

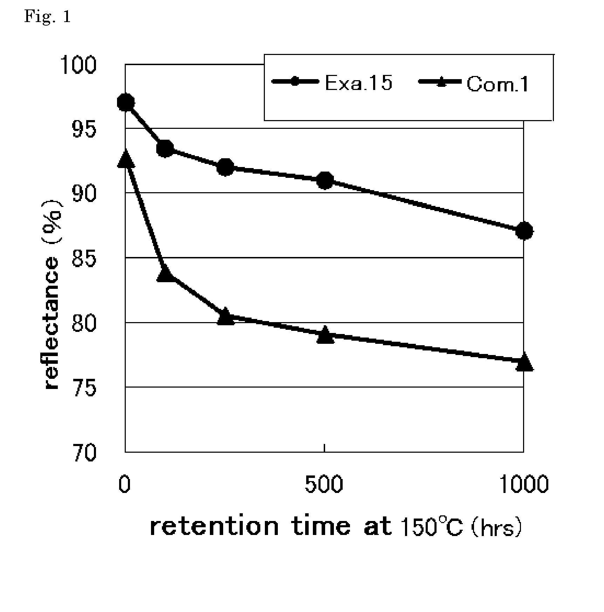

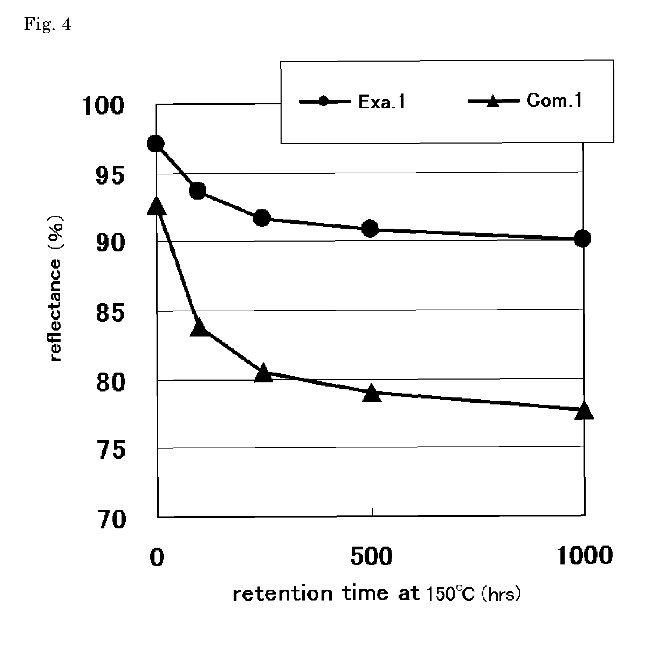

Moreover, a graph was shown in Figure 1 wherein change with time of the reflectance of the LED reflector is shown as ● indicating those of the Example 15 and shown as ▲ indicating those of the Comparative Example 1. Further, a graph was shown in Figure 4 wherein change with time of the reflectance ratio of the LED reflector regarding the Example 1 (●) and the Comparative Example 1 (▲) is shown.

### <A result of evaluation>

At first, in the present invention, an evaluation in the case that the unsaturated polyester resin (A) comprising the crystalline unsaturated polyester and a copolymerizable monomer and/or a copolymerizable prepolymer is used, can be referred to table 2.

As a result of making a comprehensive assessment as shown in table 2, in the present invention, regarding the Examples 1 to 13 satisfying the range of a formulation amount of the crystalline unsaturated polyester resin composition, a result of a granulatability is superior, an initial reflectance wherein a measurement wavelength is at 450 nm, is 90% or more, in many cases, a reflectance after test for heat resistance wherein a test piece was kept at 150 °C for 1000 hours, is 80 % or more, and further superior results were obtained in all property including a result of a dimensional stability in storage. It was revealed that if the reflectance etc., is inferior, regarding a moldability, stability etc., in whole, superior results were shown.

Moreover, in the present invention, an evaluation in the case that the unsaturated polyester resin (B) comprising the unsaturated polyester (including both crystalline and / or amorphous) and a copolymerizable monomer and/or a copolymerizable prepolymer and the thermoplastic resin is used, can be referred to table 3.

As a result of making a comprehensive assessment as shown in table 3, it was revealed that in the present invention, regarding the Examples 14 to 30 satisfying the range of a formulation amount of the unsaturated polyester resin composition, superior effects were shown comparing with the unsaturated polyester resin composition with no use of the thermoplastic resin.

The Comparative Example 1 is for an amorphous unsaturated polyester resin composition using diallyl phthalate prepolymer to an amorphous unsaturated polyester. A shrinkage of a molded article becomes high comprising with those of almost Examples. Since the viscosity of the resin composition is very high, productivity during granulation remarkably reduced. Although an initial reflectance is good, but a reflectance after test for heat resistance was lower than 80%. It was confirmed that there was a slight change of shape in the dimensional stability in storage.

The Comparative Example 2 is for an amorphous unsaturated polyester resin composition wherein the crystalline unsaturated polyester of the Example 1 is substituted for the amorphous unsaturated polyester resin, and for an amorphous unsaturated polyester resin composition wherein the crystalline unsaturated polyester of the Example 15 is substituted for the amorphous unsaturated polyester resin and a thermoplastic resin is removed. A shrinkage of a molded article is high and an image clarity is low comparing with the Examples. Since it became a continuous pellet, a granulatability reduced. It was confirmed that a dimensional stability in 50°C storage was poor and there was a change of shape of the resin composition.

As a result of making a comprehensive assessment as mentioned above, it was revealed that the unsaturated polyester resin composition is possible to attain superior properties comparing with the unsaturated polyester resin composition in the prior art. Therefore, a surface-mount-type light-emitting device with a reflector molded by the unsaturated polyester resin composition has a longer operating life comparing with a surface-mount-type light-emitting device with a reflector molded by the unsaturated polyester resin composition in the prior art.

### (An example of manufacture of a radical polymerizable resin composition for LED reflector)

### Examples 31 to 41, Comparison Examples 3 to 5

A radical polymerizable resin composition for LED reflector in the Examples 31 to 41 shown in the table 5 and in the Comparative examples 3 to 5 shown in table 6, were formulated with the formulation amount described in the following table 5 and table 6, and controlled uniformly using a neader capable of applying a heat and pressure and after that, the prepared mixture was fed into the extruder to granulate and obtain a resin composition.

The obtained radical polymerizable resin composition was molded by an injection molding machine (thermoset injection molding machine, 120 ton made by Sumitomo Heavy Industries, Ltd.) under the conditions of a die temperature of 165 °C and a curing time of 60 sec to obtain a test piece. As a die, a family mold was used wherein it is possible to obtain a test piece for tensile strength, flexural strength, compression strength and impact strength and a flat plate. The physical property evaluation of the molded test piece was carried out by the below mentioned method and was shown in the tables 5 and 6, respectively.

The following components of the formulation were used.

### (1) A radical polymerizable resin

1. An unsaturated polyester resin 1: a crystalline unsaturated polyester resin (T-855, made by Japan U-Pica Company, Ltd.)
2. An unsaturated polyester resin 2: an amorphous unsaturated polyester resin (T-8552, made by Japan U-Pica Company, Ltd)
3. Epoxy acrylate: epoxy acrylate (V-774, made by Japan U-Pica Company, Ltd)
4. A copolymerizable monomer 1: styrene monomer (made by Asahi Kasei Corporation)
5. A copolymerizable prepolymer: diallyl phthalate prepolymer (DAP polymer made by Daiso Co., Ltd.)

### (2) A white pigment

1. A white pigment : titanium oxide (rutile type titanium oxide, an average particle diameter :0.2µm) ( CR-60 made by ISHIHARA SANGYO KAISHA, LTD.)

### (3) An inorganic filler

1. An inorganic filler 1: calcium carbonate (an average particle diameter: 2 µm)

### (4) An additive agent

1. A reinforcement: glass fibers (CS 3 PE-908 made by NITTO BOSEKI CO., LTD.)
2. A release agent: zinc stearate (GF-200 made by NOF CORPORATION.)
3. A polymerization initiator: dicumyl peroxide (PERCUMYL™ D made by NOF CORPORATION.)

**[Table 5]**

| component | detailed component | unit | Exa.31 | Exa.32 | Exa.33 | Exa.34 | Exa.35 | Exa.36 | Exa.37 | Exa.38 | Exa.39 | Exa.40 | Exa.41 |
|---|---|---|---|---|---|---|---|---|---|---|---|---|---|
| radical polymerizable resin | crystalline unsaturated polyester | part by weight | 70 | 70 | 70 | 80 | 60 | 90 | 55 | 50 | | | |
| | amorphous unsaturated polyester | part by weight | | | | | | | | 20 | | 70 | 70 |
| | epoxy acrylate | part by weight | | | | | | | | | 70 | | |
| | styrene monomer | part by weight | 30 | 30 | 30 | 20 | 40 | 10 | 45 | 30 | 15 | 15 | 15 |
| | diallyl phthalate prepolymer | | | | | | | | | | 15 | 15 | 15 |
| white pigment | titanium oxide | part by weight | 100 | 100 | 100 | 100 | 100 | 30 | 100 | 100 | 100 | 100 | 100 |
| inorganic filler | calcium carbonate | part by weight | 250 | 250 | 250 | 250 | 250 | 90 | 350 | 250 | 250 | 250 | 250 |
| additive agent | glass fiber | part by weight | 80 | 80 | 80 | 80 | 80 | 80 | 80 | 80 | 80 | 80 | 80 |
| | zinc stearate | part by weight | 6 | 6 | 6 | 6 | 6 | 6 | 6 | 6 | 6 | 6 | 6 |
| | dicumyl peroxide | part by weight | 2 | 5 | 10 | 5 | 5 | 5 | 5 | 5 | 7 | 0.1 | 15 |
| physical property | dimensional stability in storage | | ○ | ○ | ○ | ○ | ○ | ○ | ○ | ○ | Δ | Δ | Δ |
| | viscosity of resin composition | kPa-s | 5 | 5 | 5 | 10 | 2 | 0.5 | 80 | 5 | 5 | 5 | 5 |
| | gel time | sec | 50 | 20 | 10 | 20 | 20 | 15 | 23 | 20 | 20 | 100 | 10 |
| | moldability | | ○ | ○ | ○ | ○ | ○ | ○ | ○ | ○ | ○ | ○ | ○ |
| | length of flash | mm | 9 | 7 | 4 | 6 | 8 | 10 | 4 | 7 | 5 | 15 | 4 |
| | molding cycle | | ○ | ○ | ○ | ○ | ○ | ○ | ○ | ○ | ○ | ○ | ○ |
| | initial reflectance | % | 97 | 97 | 97 | 97 | 97 | 94 | 92 | 98 | 94 | 97 | 97 |
| | reflectance after test for heat resistance | % | 88 | 88 | 88 | 88 | 85 | 75 | 86 | 88 | 84 | 87 | 87 |
| | 60° glossiness | % | 65 | 65 | 58 | 61 | 66 | 76 | 49 | 68 | 77 | 65 | 35 |
| comprehensive evaluation | | | ○ | ○ | ○ | ○ | ○ | ○ | ○ | ○ | ○ | Δ | Δ |

**[Table 6]**

| component | detailed component | unit | Com.1 | Com.2 | Com.3 |
|---|---|---|---|---|---|
| radical polymerizable resin | amorphous unsaturated polyester | part by weight | | 70 | 70 |
| | styrene monomer | part by weight | 30 | 15 | 15 |
| | diallyl phthalate prepolymer | part by weight | 70 | 15 | 15 |
| white pigment | titanium oxide | part by weight | 100 | 20 | 250 |
| inorganic filler | calcium carbonate | part by weight | 250 | 50 | 350 |
| additive agent | glass fiber | part by weight | 80 | 80 | 80 |
| | zinc stearate | part by weight | 6 | 6 | 6 |
| | dicumyl peroxide | part by weight | 5 | 5 | 5 |
| physical property | dimensional stability in storage | | Δ | × | Δ |
| | viscosity of resin composition | kPa·s | - | 0.01 | - |
| | gel time | sec | 25 | 15 | 25 |
| | moldability | | × | ○ | × |
| | length of flash | mm | - | 12 | - |
| | molding cycle | | - | ○ | - |
| | initial reflectance | % | - | 97 | - |
| | reflectance after test for heat resistance | % | - | 67 | - |
| | 60° glossiness | % | - | 65 | - |
| comprehensive evaluation | | | × | × | × |

### (1) A dimensional stability in storage

The radical polymerizable resin compositions for an LED reflector mentioned in the Examples 31 to 41 shown in table 5, and in the Comparison Examples 3 to 5 shown in table 6 were evaluated according to the manner described in the above paragraph [0337].

### (2) A viscosity of resin composition

A viscosity of radical polymerizable resin compositions for an LED reflector mentioned in the Examples 31 to 41 shown in table 5, and in the Comparative Examples 3 to 5 shown in table 6 were measured by using a BMC viscosimeter (BMC-100T, made by Japan U-Pica Company, Ltd). 50g of a radical polymerizable resin composition put into 90 °C of a sample pot and a piston was dropped to maintain for 3 minutes. After that, the piston is dropped with constant speed (50mm/min) to flow out a resin composition from a 4mm diameter × 10 mm length of a mono hole punctured in a center bottom of a sample pot. At that time, a viscosity was measured by a load applied to a push piston. The result of this shown in table 5 and table 6. A measurement was canceled regarding a resin composition wherein a viscosity can not be measured since it is high.

### (3) A gel time

A gel time of radical polymerizable resin compositions for an LED reflector mentioned in the Examples 31 to 41 shown in table 5, and in the Comparative Examples 3 to 5 shown in table 6 were measured by using a die with a differential transformer type position sensor. After a 240g of the resin composition was put at a central part of a press die set at 155°C, a die was immediately raised upwards and turned off to carry out heat and pressure forming. From a recorder, as shown in Figure 5, a displacement - time curve of die was obtained (A line 1 corresponds to a mold clamping speed. The more a resin composition in a die flows, the more a movement of a differential transformer becomes late, and a differential transformer stops once at a time that it becomes a constant thickness. However, since a hardening shrinkage begins according to the progress of hardening, a position of the differential transformer starts moving upward. A line of tangency on a point of inflection of an S-curve obtained at this stage is line 2. If the hardening terminated, the position of a differential transformer becomes constant. A line of tangency on a point of inflection of an S-curve obtained at this stage is line 3. A time from an intersection point 4 of line 1 and line 2 to an intersection point 5 of line 2 and line 3 was defined as a gel time.). A value of a gel time obtained from the Figure is shown in table 5 and table 6.

### (4) A filling property

A moldability of radical polymerizable resin compositions for an LED reflector mentioned in the Examples 31 to 41 shown in table 5, and in the Comparative Examples 3 to 5 shown in table 6 was evaluated under the conditions that a die temperature is 165°C and a curing time is 60 sec (the curing time: total of injection time and pressure keeping time). The result of this is shown in table 1 and table 2. Those wherein the resin composition is filled up to the end of a cavity of die are ○, those wherein the resin composition are not filled up to the end of a cavity of die are ×.

### (5) A length of flash

A length of flash other than an air vent set at a die regarding radical polymerizable resin compositions for an LED reflector mentioned in the Examples 31 to 41 shown in table 5, and in the Comparative Examples 3 to 5 shown in table 6, was evaluated under the conditions that a die temperature is 165°C and a curing time is 60 sec (the curing time: total of injection time and pressure keeping time). Regarding the evaluation method, a maximal value of a length of resin flash generated by flowing within a clearance of both a fixed side and a variable side of a die was calculated by a slide caliper. The result of this is shown in table 5 and table 6. The targeted length of flash was defined as 10 mm, those of 10 mm or less are good and those of more than 10 mm are defect.

### (6) A molding cycle

A molding cycle of radical polymerizable resin compositions for an LED reflector mentioned in the Examples 31 to 41 shown in table 5, and in the Comparative Examples 3 to 5 shown in table 6, was evaluated under the conditions that a die temperature is 165°C and a curing time is 60 sec (the curing time: total of injection time and pressure keeping time). The result of this is shown in table 5 and table 6. Those that a test piece is capable of molding continuously and a good article is obtained are ○, and those that it is impossible to mold continuously since a curing of sprue is insufficient are ×.

### (7) An initial reflectance

The test pieces of the Examples 31 to 41 shown in table 5, and the Comparison Examples 3 to 5 shown in table 6 were evaluated according to the method described in the paragraph [0338].

### (8) A reflectance after test for heat resistance

The test pieces of the Examples 31 to 41 shown in table 5, and the Comparative Examples 3 to 5 shown in table 6 were evaluated according to the method described in the paragraph [0339].

### (9) A 60 ° glossiness

The test pieces of the Examples 31 to 41 shown in table 5 and the Comparative Examples 3 to 5 shown in table 6 were measured by using a measuring instrument of an image clarity (VGS-300A made by Nippon Denshoku Industries Co., Ltd.). The results of these are shown in table 5 and table 6. The targeted glossiness is defined as 40%, those of 40 % or more are good and those of less than 40% are defective. However, even if the above precise standard is not fulfilled, since there is possibility that conditions are adopted according to a desired application and a desired quality etc., even if it is less than 40%, the standard may be thought that it is one of rough indication.

### <A result of evaluation>

It was revealed that as a result of making a comprehensive assessment as shown in table 5, in the present invention, the Examples 31 to 41 satisfying the range of a formulation amount of the radical polymerizable resin compositions for an LED reflector had a superior effect comparing with a radical polymeraizable resin compositions shown in table 6.

The Comparison Example 3 is for radical polymerizable resin compositions using diallyl phthalate prepolymer and styrene monomer. It is impossible to measure a viscosity since a viscosity of the resin composition is high and making possible to render an overload to the measuring device. It is impossible to obtain a test piece since a viscosity of the resin composition is high and the resin composition can not reach the end portion of test piece.

The Comparative Example 4 is for radical polymerizable resin compositions using styrene monomer and diallyl phthalate prepolymer to an amorphous unsaturated polyester. A reflectance after test for heat resistance of a resin composition having a large amount of resin reduced. Moreover, it was confirmed that there was a change of shape of a resin composition regarding a dimensional stability in storage.

The Comparative Example 5 is for radical polymerizable resin compositions using styrene monomer and diallyl phthalate prepolymer to an amorphous unsaturated polyester. It is impossible to measure a viscosity since a viscosity of the resin composition having a large amount of the inorganic filler is high and making possible to render an overload to the measuring device. Moreover, it is impossible to obtain a test piece since a viscosity of the resin composition is high and the resin composition cannot reach the end portion of test piece. Furthermore, it was confirmed that there was a slightly change of shape of a resin composition regarding a dimensional stability in storage.

As a result of making a comprehensive assessment as mentioned above, it was revealed that the Examples 31 to 41 satisfying the scope of the invention of the radical polymerizable resin composition for an LED reflector had a superior effect comparing with the radical polymerizable resin composition shown in table 6.

## Claims

1. A crystalline unsaturated polyester resin composition for an LED reflector comprising at least a crystalline unsaturated polyester resin and an inorganic filler, and **characterized in that** the crystalline unsaturated polyester resin comprises a crystalline unsaturated polyester and a copolymerizable monomer and/or a copolymerizable prepolymer and the crystalline unsaturated polyester resin composition contains a white pigment.

2. A crystalline unsaturated polyester resin composition for an LED reflector according to claim 1, and **characterized in that** the crystalline unsaturated polyester resin is a solid state in a temperature range of 50°C or less.

3. A crystalline unsaturated polyester resin composition for an LED reflector according to claims 1 or 2, wherein the crystalline unsaturated polyester resin comprises 40 to 95 part by weight of a crystalline unsaturated polyester, 60 to 5 part by weight of a copolymerizable monomer and/or a copolymerizable prepolymer.

4. A crystalline unsaturated polyester resin composition for an LED reflector according to any one of claims 1 to 3, wherein a copolymerizable monomer of a liquid state at a room temperature is 50 percent by weight or more for total amount of a copolymerizable monomer and/or a copolymerizable prepolymer.

5. A crystalline unsaturated polyester resin composition for an LED reflector according to any one of claims 1 to 4, wherein a crystalline unsaturated polyester resin is 10 to 35 percent by weight for total amount of composition, total amount of an inorganic filler and a white pigment is 50 to 80 percent by weight for total amount of composition, a ratio of the white pigment in total amount of the inorganic filler and the white pigment is 10 to 50 percent by weight.

6. A crystalline unsaturated polyester resin composition for an LED reflector according to claim 5, wherein a ratio of the white pigment in total amount of the inorganic filler and the white pigment is 10 to 29 percent by weight.

7. A crystalline unsaturated polyester resin composition for an LED reflector according to any one of claims 1 to 6, wherein the white pigment is at least one or more selected from a group of titanium oxide, barium titanate, barium sulfate, zinc oxide, zinc sulfide.

8. A crystalline unsaturated polyester resin composition for an LED reflector according to any one of claims 1 to 7, wherein the average particle diameter of the white pigment is 2.0 µm or less.

9. A crystalline unsaturated polyester resin composition for a LED reflector according to any one of claims 1 to 8, wherein the average particle diameter of the inorganic filler is within a range from 0.1 to 50 µm.

10. A granular material comprises the crystalline unsaturated polyester resin composition for an LED reflector according to any one of claims 1 to 9.

11. An LED reflector **characterized by** molding the granular material comprising the crystalline unsaturated polyester resin composition for an LED reflector according to claim 10.

12. An unsaturated polyester resin composition for an LED reflector comprising at least an unsaturated polyester resin and an inorganic filler, and **characterized in that** the unsaturated polyester resin comprises an unsaturated polyester, a copolymerizable monomer and/or a copolymerizable prepolymer and a thermoplastic resin, and the unsaturated polyester resin composition contains a white pigment.

13. An unsaturated polyester resin composition for an LED reflector according to claim 12, wherein the unsaturated polyester resin comprises 99 to 55 part by weight of total amount of the unsaturated polyester and a copolymerizable monomer and/or a copolymerizable prepolymer, and 1 to 50 part by weight of the thermoplastic resin.

14. An unsaturated polyester resin composition for an LED reflector according to claims 12 or 13, wherein an unsaturated polyester resin is 10 to 35 percent by weight for total amount of composition, total amount of an inorganic filler and a white pigment is 50 to 80 percent by weight for total amount of composition, a ratio of the white pigment in total amount of the inorganic filler and the white pigment is 10 to 50 percent by weight.

15. An unsaturated polyester resin composition for an LED reflector according to any one of claims 12 to 14, wherein the unsaturated polyester resin contains at least crystalline unsaturated polyester resin.

16. An unsaturated polyester resin composition for an LED reflector according to any one of claims 12 to 15, **characterized in that** the unsaturated polyester resin is a solid state in a temperature range of 50°C or less.

17. An unsaturated polyester resin composition for an LED reflector according to any one of claims 12 to 16, wherein a copolymerizable monomer of a liquid state at a room temperature is 50 percent by weight or more for total amount of a copolymerizable monomer and/or a copolymerizable prepolymer.

18. An unsaturated polyester resin composition for an LED reflector according to any one of claims 12 to 17, wherein a ratio of the white pigment in total amount of the inorganic filler and the white pigment is 10 to 29 percent by weight.

19. An unsaturated polyester resin composition for an LED reflector according to any one of claims 12 to 18, wherein the white pigment is at least one or more selected from a group of titanium oxide, barium titanate, barium sulfate, zinc oxide, zinc sulfide.

20. An unsaturated polyester resin composition for an LED reflector according to any one of claims 12 to 19, wherein the average particle diameter of the white pigment is 2.0 µm or less.

21. An unsaturated polyester resin composition for a LED reflector according to any one of claims 12 to 20, wherein the average particle diameter of the inorganic filler is within a range from 0.1 to 50 µm.

22. An unsaturated polyester resin composition for a LED reflector according to any one of claims 12 to 21, wherein a thermoplastic resin is selected from a group consisting of polymethyl methacrylate, polystyrene, acrylonitrile butadiene styrene, polyethylene, polypropylene, polyvinyl acetate, styrene-butadiene rubber, and copolymer thereof.

23. A granular material comprising the unsaturated polyester resin composition for a LED reflector according to any one of claims 12 to 22.

24. An LED reflector produced by molding the granular material comprising the unsaturated polyester resin composition for a LED reflector according to claim 23.

25. A radical polymerizable resin composition for LED reflector comprising at least a radical polymerizable resin, an inorganic filler, a white pigment, wherein a degree of viscosity of the radical polymerizable resin composition is in a range from 0.1 to 100 kPa-s.

26. A radical polymerizable resin composition for LED reflector according to claim 25, wherein a degree of viscosity of the radical polymerizable resin composition is in a range from 0.1 to 100kPa-s in a temperature range from 70 to 120°C.

27. A radical polymerizable resin composition for LED reflector according to claims 25 or 26, wherein the radical polymerizable resin composition contains an unsaturated polyester resin.

28. A radical polymerizable resin composition for LED reflector according to any one of claims 25 to 27, wherein the radical polymerizable resin composition contains a crystalline unsaturated polyester resin.

29. A radical polymerizable resin composition for LED reflector according to any one of claims 25 to 28, wherein in the radical polymerizable resin composition, a gel time in a temperature range from 140 to 180°C is in a range of 5 to 120 sec.

30. A granular material comprising the radical polymerizable resin composition for LED reflector according to any one of claims 25 to 29.

31. An injection molding process of heat-hardening a granular material comprising the radical polymerizable resin composition for LED reflector according to claim 30 at 140 to 180 °C.

32. An LED reflector **characterized by** the injection molding process according to claim 31.

33. A surface-mount-type light-emitting device with an LED reflector made by molding an unsaturated polyester resin composition comprising at least an unsaturated polyester resin and an inorganic filler, and **characterized in that** the unsaturated polyester resin comprises one or more selected from (A) an unsaturated polyester resin comprising an the crystalline unsaturated polyester, a copolymerizable monomer and/or a copolymerizable prepolymer, or (B) an unsaturated polyester resin comprising an unsaturated polyester, a copolymerizable monomer and/or a copolymerizable prepolymer, and a thermoplastic resin, and the unsaturated polyester resin composition contains a white pigment.

34. A surface-mount-type light-emitting device according to claim 33, wherein the unsaturated polyester resin (A) comprises 40 to 95 part by weight of a crystalline unsaturated polyester, 60 to 5 part by weight of a copolymerizable monomer and/or a copolymerizable prepolymer.

35. A surface-mount-type light-emitting device according to claim 33, wherein the unsaturated polyester resin (B) comprises 99 to 50 part by weight of the mixture comprising 35 to 95 part by weight of unsaturated polyester and 60 to 5 part by weight of a copolymerizable monomer and/or a copolymerizable prepolymer, and 1 to 50 part by weight of the thermoplastic resin.

36. A surface-mount-type light-emitting device according to any one of claims 33 to 35, wherein the unsaturated polyester resin (A) and/or (B) is 10 to 35 percent by weight for total amount of composition, total amount of the inorganic filler and the white pigment is 50 to 80 percent by weight for total amount of composition, and a ratio of the white pigment in total amount of the inorganic filler and the white pigment is 10 to 50 percent by weight.

37. A surface-mount-type light-emitting device according to any one of claims 33 to 36, wherein the unsaturated polyester resin (A) and/or (B) is a solid state in a temperature range of 50°C or less.

38. A surface-mount-type light-emitting device according to any one of claims 33 to 37, wherein the unsaturated polyester resin (B) contains at least a crystalline unsaturated polyester.

39. A surface-mount-type light-emitting device according to any one of claims 33 to 38, wherein the device contains the molded article comprising the unsaturated polyester resin composition wherein the copolymerizable monomer of a liquid state at a room temperature is 50 percent by weight or more for total amount of the copolymerizable monomer and/or the copolymerizable prepolymer.

40. A surface-mount-type light-emitting device according to any one of claims 33 to 39, wherein a ratio of the white pigment in total amount of the inorganic filler and the white pigment is 10 to 29 percent by weight.

41. A surface-mount-type light-emitting device according to any one of claims 33 to 40, wherein the white pigment is at least one or more selected from a group of titanium oxide, barium titanate, barium sulfate, zinc oxide, zinc sulfide.

42. A lighting device equipped with a surface-mount-type light-emitting device according to any one of claims 33 to 41.

43. An image display device equipped with a surface-mount-type light-emitting device according to any one of claims 33 to 41.
